(19) **Europäisches Patentamt / European Patent Office / Office européen des brevets**

(11) **EP 4 528 813 A1**

(12) **EUROPEAN PATENT APPLICATION**
published in accordance with Art. 153(4) EPC

(43) Date of publication:
26.03.2025 Bulletin 2025/13

(21) Application number: 23884327.0

(22) Date of filing: 26.07.2023

(51) International Patent Classification (IPC):
*H01L 23/552* (2006.01)    *G01S 7/02* (2006.01)
*G01S 7/36* (2006.01)    *H01F 27/36* (2006.01)

(52) Cooperative Patent Classification (CPC):
G01S 7/02; G01S 7/36; G01S 7/41; H01F 27/36;
H01L 23/552; H03B 5/12; H03L 7/093; H03L 7/099;
H03L 7/18; H10D 84/00

(86) International application number:
PCT/CN2023/109342

(87) International publication number:
WO 2024/093388 (10.05.2024 Gazette 2024/19)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 01.11.2022 CN 202211358788

(71) Applicant: Calterah Semiconductor Technology
(Shanghai) Co., Ltd
Shanghai 201210 (CN)

(72) Inventors:
• YANG, Jianwei
Shanghai 201210 (CN)
• ZHOU, Wenting
Shanghai 201210 (CN)

(74) Representative: Dragotti & Associati S.R.L.
Via Nino Bixio, 7
20129 Milano (IT)

(54) **SEMICONDUCTOR INTEGRATED CIRCUIT, PHASE-LOCKED LOOP, RADAR AND ELECTRONIC DEVICE**

(57)    A semiconductor integrated circuit, a phase-locked loop, a radar sensor and an electronic device. The semiconductor integrated circuit comprises a substrate layer and a plurality of insulated metal layers, which are arranged on the substrate layer, wherein the plurality of metal layers comprise a shielding structure layer (100), a first device structure layer and a plurality of second device structure layers. The semiconductor integrated circuit contains an oscillator used for outputting a differential signal, and the oscillator contains: a first inductor and a second inductor, which are formed in different second device structure layers; a capacitor device, which is formed in the first device structure layer; and a first transistor and a second transistor, which are formed in the substrate layer, wherein the first inductor and the second inductor are symmetric about the same axis of symmetry, and the shielding structure layer is provided with a shielding structure used for shielding interference signals leaked by the first inductor and/or the second inductor.

FIG. 3

## Description

The present application claims priority of Chinese Patent Application No. 202211358788.4, entitled "Semiconductor Integrated Circuit, Phase-locked Loop, Radar and Electronic Device", filed to the CNIPA on November 1, 2022, the contents of which should be understood to be incorporated herein by reference.

### Technical field

Embodiments of the present disclosure relate to, but are not limited to, the technical field of semiconductors, and particularly relate to a semiconductor integrated circuit, a phase-locked loop, a radar sensor, and an electronic apparatus.

### Background

In integrated circuits, an inductor is an important electrical device, and its performance parameter directly affects the performance of the integrated circuits. A quality factor Q value of the inductor is a ratio of energy stored in the inductor to energy lost. Therefore, the higher the quality factor Q value of the inductor, the higher the efficiency and the better the performance of the inductor.

A voltage controlled oscillator (VCO) circuit includes two inductor devices. When the quality factor Q values of the inductors are low, it will not only increase the loss, but also cause interference to other devices in the VCO circuit.

### Summary

The following is a summary of the subject matter described in detail herein. This summary is not intended to limit the scope of protection of the claims.

Embodiments of the present disclosure provide a semiconductor integrated circuit, a phase-locked loop, a radar sensor, and an electronic apparatus.

In one aspect, embodiments of the present disclosure provide a semiconductor integrated circuit including: a base substrate layer, and a plurality of metal layers disposed on the base substrate layer and insulated from each other; wherein the plurality of metal layers includes: a shielding structure layer, a first device structure layer, and a plurality of second device structure layers, and the semiconductor integrated circuit includes an oscillator for outputting differential signals; the oscillator includes a first inductor and a second inductor that are formed on different second device structure layers, a capacitor device formed on the first device structure layer, a first transistor and a second transistor that are formed on the base substrate layer; wherein the first inductor and the second inductor are symmetric with respect to a same axis of symmetry; and the shielding structure layer is formed with a shielding structure for shielding interference signals leaked by the first inductor and/or the second inductor.

In another aspect, embodiments of the present disclosure further provide a voltage controlled oscillator including the semiconductor integrated circuit of any of the above-described embodiments.

In yet another aspect, embodiments of the present disclosure further provide a phase-locked loop including a frequency phase detector, a charge pump, a filter, and an oscillator and a frequency divider arranged in the semiconductor circuit; wherein a first input terminal of the frequency phase detector is an input terminal of the phase-locked loop, a second input terminal of the frequency phase detector is connected with an output terminal of the frequency divider, and an output terminal of the frequency phase detector is connected with an input terminal of the charge pump; and an output terminal of the charge pump is connected with an input terminal of the filter, an output terminal of the filter is connected with a control terminal of the oscillator, and an output terminal of the oscillator is connected with an input terminal of the frequency divider.

In still yet another aspect, embodiments of the present disclosure further provide a radar sensor including a signal receiving module, a signal transmitting module, and a clock source, wherein the signal transmitting module is configured to transmit an electromagnetic wave signal via a transmitting antenna based on a reference frequency provided by a phase-locked loop in the clock source, and the signal receiving module is configured to receive an echo reflected by a target object using the receiving antenna, and perform down-conversion processing based on the reference frequency provided by the phase-locked loop in the clock source to generate and output an intermediate frequency signal; wherein the phase-locked loop is the phase-locked loop of any one of the above-described embodiments.

In also still yet another aspect, an embodiment of the present disclosure further provides an electronic apparatus including an oscillator as described in the previous embodiment, a phase-locked loop as described in the previous embodiment, or a radar sensor as described in the previous embodiment.

By providing the shielding structure the first inductor and the second inductor may be stacked, the overall size can be reduced and interference reduction can be achieved. By providing a symmetry axis of the first inductor to coincide with a symmetry axis of the second inductor, on the one hand, the electromagnetic/current influence of the first inductor on the second inductor can be reduced, and on the other hand, the circuit size can be reduced.

In also again still yet another aspect, embodiments of the present disclosure further provide a semiconductor structure, including a device structure layer and a shielding structure layer disposed in insulation; the device structure layer is provided with at least one inductor device, and the shielding structure layer is provided with a first shielding structure for shielding an interference signal leaked by the inductor device.

The inductive device includes an annular inductor structure including a plurality of segments, which are sequentially connected to form a non-closed polygonal symmetrical structure, and each segment includes a plurality of metal strips arranged in a same direction and in parallel.

The first shielding structure includes a plurality of sub-structures, each of which corresponds to a segment of the annular inductor structure and includes a plurality of metal wires arranged in parallel, wherein one terminal of each of the plurality of metal wires of the plurality of sub-structures is connected by a metal wire and the other terminal is disconnected to form a non-closed charge cancellation path, and an extension direction of metal wires in each sub-structure is perpendicular to an extension direction of metal strips in a segment of the annular inductor structure corresponding to the sub-structure.

By providing a shielding structure composed of metal wires below the metal strips of the inductor device, since the extension direction of the metal wires in the shielding structure is perpendicular to the extension direction of the metal strips of the inductor device, and one terminal of each metal wire is connected with each other through a metal path and the other terminal is disconnected, the charge cancellation path thus formed may cancel the interference signals of different current directions leaked by a plurality of groups of metal strips in the inductor device as much as possible through the metal wires perpendicular to the current directions, so as to achieve the purpose of reducing the influence on other devices.

Other features and advantages of the present disclosure will be set forth in the description below, and in part will become apparent from the specification, or may be learned by practicing the present disclosure. Other advantages of the present disclosure may be achieved and obtained by the solutions described in the specification and the accompanying drawings.

After the drawings and detailed description are read and understood, other aspects can be understood.

Brief Description of Drawings

The accompanying drawings are used for providing understanding of technical solutions of the present disclosure, and form a part of the specification. They are used for explaining the technical solutions of the present disclosure together with the embodiments of the present disclosure, but do not form a limitation on the technical solutions of the present disclosure.

FIG. 1 is a schematic diagram of various layers of a semiconductor integrated circuit according to the present embodiment.

FIG. 2 is a schematic diagram of a circuit of the semiconductor integrated circuit according to the present embodiment.

FIG. 3 is a schematic diagram of a semiconductor structure according to an embodiment of the present disclosure.

FIG. 4 is a schematic diagram of a first inductor according to an embodiment of the present disclosure.

FIG. 5 is a schematic diagram of an annular inductor structure in the first inductor shown in FIG. 4.

FIG. 6 is a schematic diagram of a shielding structure according to an embodiment of the present disclosure.

FIG. 7 is a schematic diagram of the first shielding structure shown in FIG. 6.

FIG. 8 is a comparison diagram of inductance Q values with or without a shielding structure.

FIG. 9 is a schematic diagram of another semiconductor structure according to an embodiment of the present disclosure.

FIG. 10 is a schematic diagram of another first inductor according to an embodiment of the present disclosure.

FIG. 11 is a schematic diagram of an annular inductor structure in the first inductor shown in FIG. 10.

FIG. 12 is a schematic diagram of a second inductor in the embodiment shown in FIG. 9.

FIG. 13 is a schematic diagram of another shielding structure according to an embodiment of the present disclosure.

FIG. 14 is a schematic diagram of another second shielding structure according to an embodiment of the present disclosure.

FIG. 15 is a comparison diagram of inductance Q values with or without a shielding structure.

FIG. 16 is a schematic diagram of a circuit of a phase-locked loop according to an embodiment of the present disclosure.

FIG. 17 is a schematic diagram of a radar sensor according to an embodiment of the present disclosure.

FIG. 18 is a schematic diagram of another radar sensor according to an embodiment of the present disclosure.

Detailed Description

Multiple embodiments are described in the present disclosure, but the description is exemplary rather than restrictive. It will be apparent to those of ordinary skills in the art that there may be more embodiments and implementation solutions within the scope contained in the embodiments described in the present disclosure. Although many possible feature combinations are shown in the drawings and discussed in the detailed description, many other combinations of disclosed features are possible. Unless expressly limited, any feature or element of any embodiment may be used in combination with, or may replace, any other feature or element in any other embodiment.

The present disclosure includes and contemplates combinations with features and elements known to those of ordinary skill in the art. The disclosed embodiments, features and elements of the present disclosure may also be combined with any conventional features or elements to form the unique solutions defined by the claims. Any feature or element of any embodiment may also be combined with features or elements from other solutions to form another unique solution defined by the claims. Accordingly, it should be understood that any of the features shown and/or discussed in the present disclosure may be implemented alone or in any suitable combination. Thus the embodiments are not subject to limitations other than those made in accordance with the appended claims and their equivalent substitutions. In addition, various modifications and changes can be made within the protection scope of the appended claims.

In addition, when representative embodiments are described, a method and/or process may have already been presented in a specific sequence of acts in the specification. However, to an extent that the method or process does not depend on the specific sequence of the acts herein, the method or process should not be limited to the acts in the specific sequence. Those of ordinary skills in the art will understand that other sequences of acts may also be possible. Therefore, the specific sequence of the acts illustrated in the specification should not be interpreted as a limitation on claims. In addition, the claims directed to the method and/or process should not be limited to performing the acts according to the written sequence. Those skilled in the art may easily understand that these sequences may be changed, and the changed sequences are still maintained in the essence and scope of the embodiments of the present disclosure.

In the present specification, a transistor refers to an element including at least three terminals, that is, a gate electrode, a drain electrode, and a source electrode. The transistor has a channel region between a drain electrode (a drain electrode terminal, a drain region, or a drain) and a source electrode (a source electrode terminal, a source region, or a source), and a current may flow through the drain electrode, the channel region, and the source electrode.

In the present specification, the first electrode may be a drain electrode, the second electrode may be a source electrode, or the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, in the present specification, the "first electrode" and the "second electrode" may be interchanged with each other.

In the present specification, an "electrical connection" includes a case that constituent elements are connected together through an element with a certain electrical action. An "element with a certain electrical action" is not particularly limited as long as electrical signals between the connected constituent elements may be sent and received. Examples of the "element with a certain electrical action" not only include an electrode and a wiring, but also include a switching element (such as a transistor), a resistor, an inductor, a capacitor, another element with various functions, etc.

In the present specification, "parallel" means that an angle formed by two straight lines is close to 0° within an allowable range of process/engineering errors. For example, the angle is substantially - 10° or more and 10° or less, so it also includes the angle that is - 5° or more and 5° or less. In addition, "perpendicular" means that an angle formed by the two straight lines is close to 90° within an allowable range of process/engineering errors. For example, the angle is substantially 80° or more and 100° or less, so it also includes the angle that is 85° or more and 95° or less.

Herein, "two or more" includes two, and "a plurality" has the same meaning as "two or more".

Herein, "projection" refers to "orthographic projection".

Herein, the numerical ranges given include boundary values.

A quality factor Q of an inductor is low because an electric field generated by the inductor induces charges of opposite polarities in a corresponding part of the base substrate. There is an alternating current voltage difference between different parts of the inductor, which leads to an AC voltage difference between the corresponding base substrates. The base substrate is a semiconductor, and if there is a voltage difference, there must be a current, which becomes a capacitive coupling base substrate current. This current will cause ohmic loss and reduce the quality factor Q of the inductor.

The inventors have found that in some circuits containing a plurality of inductor devices, such as a VCO circuit, since a current induced by the inductance is large, interference is prone to occur between the plurality of inductor devices, and thus the plurality of inductor devices have a large spacing between them, so that the overall size of the semiconductor integrated circuit is larger or the number of layers is larger. In addition, a large induced current is prone to cause interference to other circuit devices in and outside the VCO circuit. Therefore, embodiments of the present application provide a semiconductor integrated circuit, which reduces the overall size and achieves the purpose of reducing interference by redesigning the inductor structure.

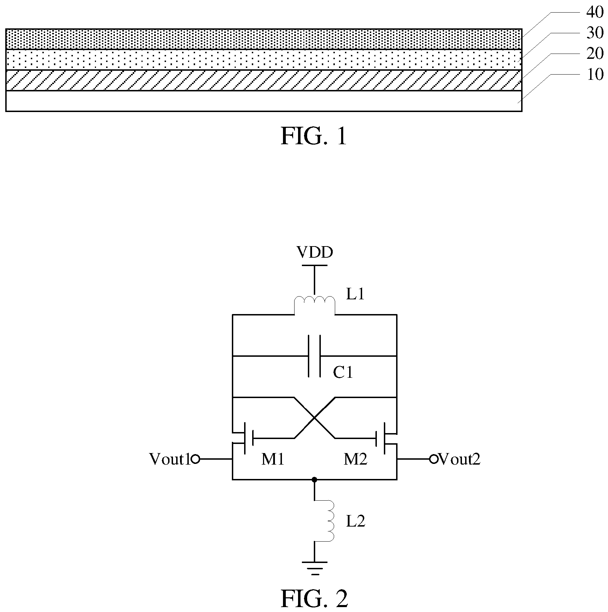

FIG. 1 is a schematic diagram of various layers of a semiconductor integrated circuit according to the present embodiment, which may be applied in a VCO circuit or other similar circuits. The semiconductor integrated circuit includes a base substrate layer 10, and a plurality of metal layers sequentially disposed on the base substrate layer 10 and insulated from each other. The plurality of metal layers includes a shielding structure layer 20, a first device structure layer 30, and a plurality of second device structure layers 40 (insulation layers between the metal layers are not shown in FIG. 1). The semiconductor integrated circuit includes an oscillator including a first inductor, a second inductor, a capacitor device, a first transistor, and a second transistor. Herein the first inductor and the second inductor are stacked on different second device structure layers 40 and are symmetrical about a same symmetry axis. The oscillator is configured to output differential signals, the capacitor device is provided on the first device structure layer 30, and the first transistor and the second transistor are provided on the base substrate layer 10. The shielding structure layer 20 is provided with a shielding structure for shielding interference signals leaked by the inductive device (the first inductor and/or second inductor).

By providing the shielding structure the first inductor and the second inductor may be stacked, the overall size can be reduced and interference reduction can be achieved. By setting a symmetry axis of the first inductor to coincide with a symmetry axis of the second inductor, on the one hand, the electromagnetic/current influence of the first inductor on the second inductor can be reduced, and on the other hand, the circuit size can be reduced.

In an exemplary embodiment, a shape of the shielding structure may correspond to a shape of the first inductor (e.g., the same shape as that of the first inductor) to shield interference signals leaked by the first inductor. The shielding structure may include a non-closed charge cancellation path formed by arranging a plurality of metal wires, wherein the plurality of metal wires are arranged along a current direction in the first inductor, and an extension direction of the plurality of metal wires is perpendicular to an orthographic projection of the current direction. Assuming that the current direction in the inductor is a straight line direction from A to B to C to D, a metal wire a may be provided at a projection position of A, a metal wire b may be provided at a projection position of B, a metal wire c may be provided at a projection position of C, and a metal wire D may be provided at a projection position of D. The metal wires a, b, c, and d are provided in parallel and extend in the same direction, each of which is perpendicular to the current direction from A to D.

For example, the first inductor includes a plurality of groups of metal strips, current directions on different groups of metal strips are different, and a current direction on a same group of metal strips is the same; the shielding structure includes a plurality of groups of metal wires, each group of metal wires corresponds to a group of metal strips, a projection of each group of metal wires on the base substrate layer is overlapped with a projection of its corresponding group of metal strips on the base substrate layer, and an extension direction of each group of metal wires is perpendicular to a current direction of its corresponding group of metal strips. By providing a shielding structure composed of metal wires below the metal strips of the inductor device, since the metal wires in the shielding structure are perpendicular to directions of the current of the metal strips of the inductor device, and one terminal of each metal wire is connected with each other through a metal path and the other terminal is disconnected, the charge cancellation path thus formed may cancel the interference signals of different current directions leaked by a plurality of groups of metal strips in the inductor device as much as possible through the metal wires perpendicular to the current directions, so as to achieve the purpose of reducing the influence on other devices.

The overlapping or lapping between any inductor and the shielding structure mentioned herein means that a projection of a corresponding inductor is completely covered by the shielding structure, i.e., an orthographic projection of the shielding structure contains an orthographic projection of the corresponding inductor.

In an exemplary embodiment, a projection of the capacitor device on the base substrate layer does not coincide with the projection of the shielding structure on the base substrate layer to prevent the shielding layer from interfering with the capacitor. The capacitor may be formed by two layers of metal thin films in the first device layer. Exemplarily, the first device structure layer provided with the capacitor device is located between the second device structure layer and the shielding structure layer.

In an exemplary embodiment, the metal wires in the shielding structure may be provided without a closed loop, which may prevent the formation of a current loop in the shielding structure and avoid increasing losses.

FIG. 2 is a schematic diagram of a circuit of an oscillator of the present embodiment. As shown in the FIG. 2, the oscillator includes a first inductor L1, a second inductor L2, a capacitor C1, a first transistor M1 and a second transistor M2. Herein, a first terminal of the first inductor L1 is connected to a first terminal of the capacitor C1, a first electrode of the first transistor M1, and a control electrode of the second transistor M2, a second terminal of the first inductor L1 is connected to a second terminal of the capacitor C1, a first electrode of the second transistor M2, and a control electrode of the first transistor M1, and a power supply terminal (i.e., a control terminal) of the first inductor L1 is connected to a voltage terminal VDD. A second electrode of the first transistor M1 is connected to a first terminal of the second inductor L2, a second electrode of the second transistor M2 is connected to a first terminal of the second inductor L2, and a second terminal of the second inductor L2 is grounded. The second electrode of the first transistor M1 is connected to a first output terminal Vout1 of the oscillator, and a second electrode of the second transistor M2 is connected to a second output terminal Vout2 of the oscillator. When VDD changes, according to the formulae v (t) = L * di/dt, f = 1/ ( $2 \pi \sqrt{LC}$ ), the frequency of the output signal of the oscillator changes. In the formulae, i is an instantaneous value of a current in inductance L1, v (t) is an instantaneous value of a voltage at time t, and L and C are the inductance L1 and capacitance C1 of the oscillator. A first output terminal and a second output terminal of the oscillator output differential signals.

In an exemplary embodiment, the first inductor includes a non-closed polygonal annular inductor structure, and two rectangular inductor structures respectively connected in one-to-one correspondence with two terminals of the annular inductor structure; the annular inductor structure is an axisymmetric structure, and the two rectangular inductor structures and the annular inductor structure are symmetric with respect to the same symmetry axis, that is, the symmetry axis of the two rectangular inductor structures coincide with the symmetry axis of the annular inductor structure. The two rectangular inductor structures include a first terminal and a second terminal (terminals not connected with the annular inductor structure) arranged symmetrically, and the first terminal and the second terminal are the first terminal and the second terminal of the first inductor L1.

In an exemplary embodiment, the annular inductor structure further includes a control terminal located at a position on the symmetry axis.

Herein, the first inductor includes an annular inductor structure, a first connection portion and a second connection portion. The annular inductor structure is a non-closed polygonal symmetric structure, and the annular inductor structure includes a plurality of segments, which are sequentially connected to form the non-closed polygonal symmetric structure. The first segment in the plurality of segments is a head segment, and the last segment is a tail segment. Each segment includes a plurality of metal strips arranged in the same direction (i.e. disposed in parallel), the metal strips in each segment are connected in one-to-one correspondence with the metal strips in an adjacent segment, and the annular inductor structure is symmetrical with respect to a first symmetry axis. The first connection portion includes a first connection sub-portion and a second connection sub-portion symmetrical with respect to the first symmetry axis (the first connection sub-portion and the second connection sub-portion are the above-described rectangular inductor structures. In some other embodiments, the first connection sub-portion and the second connection sub-portion may be other shapes, such as square or irregular polygon), wherein the first connection sub-portion is connected to the head segment of the plurality of segments in the annular inductor structure, the second connection sub-portion is connected to the tail segment of the plurality of segments in the annular inductor structure, the first connection sub-portion is the first terminal of the first inductor, and the second connection sub-portion is the second terminal of the first inductor.

The second connection portion is connected with the annular inductor structure, and is located on a side of the annular inductor structure away from the first connection portion and extends in a direction away from the first connection portion. A center line of the second connection portion coincides with the first symmetry axis, this second connection portion is a control terminal of the first inductor and also a control terminal of the oscillator, so it can be seen that the control terminal of the oscillator is located on the first symmetry axis, and a first output terminal and a second output terminal of the oscillator are symmetrical with respect to the first symmetry axis.

Optionally, each connection sub-portion may be composed of a plurality of metal strips disposed in parallel. A width and a spacing of the metal strips of the connection sub-portion may be the same as a width and a spacing of the metal strips in the annular inductor structure.

Optionally, the non-closed polygon may be a quadrilateral, a pentagon, a hexagon, a heptagon, an octagon, or a nonagon. That is, a projection of the annular inductor structure on the base substrate layer may be a quadrilateral, a pentagonal, a hexagonal, a heptagonal, an octagonal, or a nonagonal.

In an exemplary embodiment, the number and width of metal strips and the spacing between metal strips in the annular inductor structure may be set as needed, and different inductance values may be obtained by adopting different sizes and numbers. For example, each segment of the annular inductor structure may include 8 to 15 metal strips disposed in parallel, and each metal strip has a width of $2\mu m$ to $2.2\mu m$, and a spacing between adjacent metal strips ranges from $1.5\mu m$ to $1.8\mu m$; or each segment of the annular inductor structure may include 3 to 5 metal strips disposed in parallel, and each metal strip has a width of $9\mu m$ to $14\mu m$, and a spacing between adjacent metal strips ranges from $1.8\mu m$ to $2.2\mu m$. Due to the skin effect of the inductor, the current is concentrated on the surface, and when the width and spacing of the metal strips reach the limits allowed by the process, the surface area of the inductor is increased to the maximum, thus reducing the loss of the skin effect.

In order to achieve shielding of the induced current of the first inductor, the shielding structure layer includes a first shielding structure. The first shielding structure includes a plurality of groups of metal wires arranged in extending directions of the sides of the polygon of the annular inductor structure; wherein one terminal portion of each metal wire of each group of metal wires is connected to one terminal portion of a metal wire of an adjacent group of metal wires, and the other terminal portion of each metal wire of each group of metal wires is disconnected (i.e. suspended), such that the connected different groups of metal wires form a non-closed charge cancellation path. The first shielding structure is configured to shield the induced current of the annular inductor structure. The first shielding structure includes a plurality of sub-structures. Each sub-structure corresponds to a segment of the annular inductor structure, each sub-structure includes a plurality of metal wires disposed in parallel, and an extension direction of the metal wires in each sub-structure is perpendicular to an extension direction of the metal strips in the segment of the annular inductor structure corresponding to the sub-structure. The first shielding sub-structure further includes a sub-structure for shielding the first connection sub-portion and a sub-structure for shielding the second connection sub-portion which are disposed symmetrically. Each sub-structure includes a plurality of metal wires in a parallel connection mode and without a loop, wherein each sub-structure includes a group of parallel metal wires arranged in a rectangle shape, one terminal portion of each metal wire of the same group of metal wires is connected to each other and the other terminal portion is disconnected, and the two sub-structures are connected through a metal wire, so that the two sub-structures as a whole form a non-closed charge cancellation path.

Corresponding to the shape of the annular inductor structure of the first inductor, a projection of the first shielding structure on the base substrate layer may be quadrilateral, pentagonal, hexagonal, heptagonal, octagonal or nonagonal.

In an exemplary embodiment, the sub-structure for shielding the first connection sub-portion and the sub-structure for shielding the second connection sub-portion in the first shielding structure are not connected to the sub-structure for shielding the annular inductor structure.

In an exemplary embodiment, in a direction parallel to the base substrate, the first connection sub-portion and the second connection sub-portion are arranged along a first direction x. The first connection sub-portion includes a first main body structure and a first branch structure, wherein the first main body structure is connected to the head segment of the annular inductor structure and includes a plurality of metal strips extending towards a second direction, and the first branch structure is connected to a metal strip, close to the second connection sub-portion, in the plurality of metal strips and extends towards the second connection sub-portion. The second connection sub-portion includes a second main body structure and a second branch structure, wherein the second main body structure is connected to the tail segment of the annular inductor structure and includes a plurality of metal strips extending towards the second direction, and the second branch structure is connected to a metal strip, close to the first connection sub-portion, in the plurality of metal strips and extends toward the first connection sub-portion. The first direction is perpendicular to the second direction.

In an exemplary embodiment, the second inductor may be provided as a metal structure extending along the direction of the symmetry axis, and a projection of the second inductor is partially or entirely located within a region enclosed and uncovered by the projection of the first inductor. Since electromagnetic influences generated when the first inductor and the second inductor are on the same axis of symmetry cancel each other, the mutual influence between different inductors is minimized, and thus the design of the second inductor to extend along the direction of the symmetry axis of the first inductor can reduce the influence on the first inductor and reduce the device area. The positional relationship between the second inductor and the first inductor, that is, the positional relationship between the projection of the second inductor and the projection of the first inductor, depends on the design needs, and the smaller the overlapping region of the projections, the less the interference.

Exemplarily, the second inductor includes one or more of the following connection structures: a coil structure symmetrical with respect to the symmetry axis, a bent structure arranged along the direction of the symmetry axis, and a strip-shaped structure arranged along the direction of the symmetry axis.

For example, the second inductor may be of a strip-shaped structure, wherein one terminal of the strip-shaped structure is a first terminal of the second inductor, and the other terminal of the strip-shaped structure is a second terminal of the second inductor. An extension direction of the second inductor is the same as the extension direction of the first inductor, and a projection of the symmetry axis of the second inductor coincides with a projection of the symmetry axis of the first inductor. The semiconductor structure with dual inductors may be applied in a voltage controlled oscillator (VCO) circuit. Optionally, a width of the strip-shaped structure of the second inductor may be $4.4\,\mu m$ to $6.6\,\mu m$, and the width of the strip-shaped structure of the second inductor is a length in a direction perpendicular to the symmetry axis of the second inductor. In the present example, the inductance value of the second inductor is small, and a special shielding structure may not be provided.

For another example, the second inductor may include a coil structure, which may be a structure obtained by rotating a metal strip for multiple rounds. The head terminal and the tail terminal of the coil structure may extend in the same direction to increase an area of the second inductor, and two terminals of the coil structure are the first terminal and the second terminal of the second inductor, respectively. A projection of a center line of the second inductor coincides with a projection of the symmetry axis of the first inductor, to reduce electromagnetic interference of the first inductor to the second inductor. Optionally, a width of the metal strips in the second inductor may be 4.4μm to 6.6μm, and a spacing between adjacent metal strips may be 1.5μm to 1.8μm. Exemplarily, orthographic projections of the first terminal and the second terminal of the second inductor are both located on an orthographic projection of the symmetry axis of the first inductor.

For another example, the second inductor may include a bent structure arranged in the direction of the symmetry axis, and is similar to the above-described coil structure, except that the metal strip constituting the second inductor is not rotated into a complete coil, and the second inductor may be bent in a U-shape, or bent in an S-shape, for example. The orthographic projections of the first terminal and the second terminal of the second inductor may both be located on the symmetry axis, or the orthographic projections of the first and second terminals of the second inductor may be symmetric with respect to the symmetry axis of the first inductor.

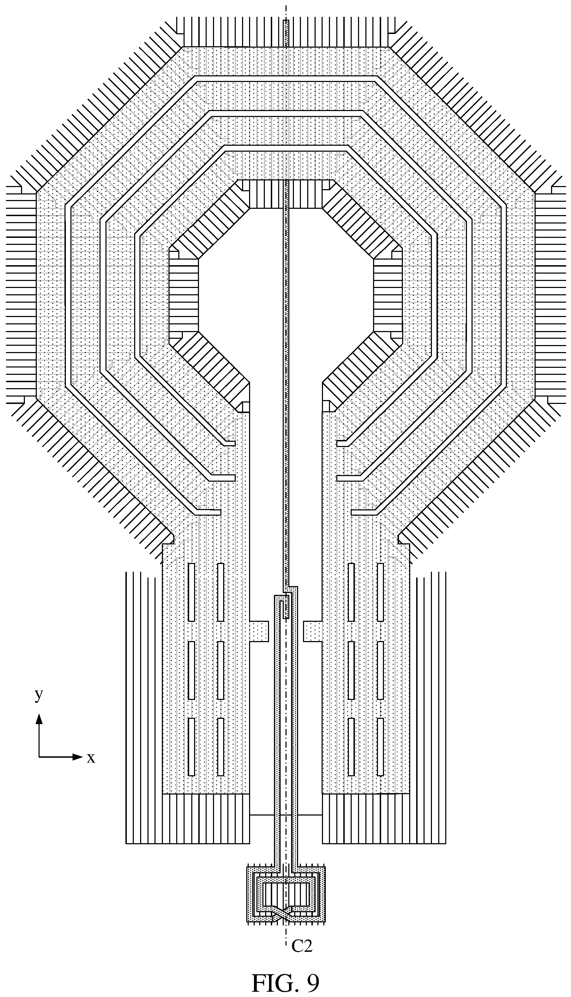

Optionally, a second shielding structure may be provided for the coil structure, and the second shielding structure is configured to shield interference signals leaked by a part of the second inductor outside a region covered by the first inductor (for example, the part of the coil structure in FIG. 9). The second shielding structure includes a plurality of metal wires arranged in parallel, and the plurality of metal wires are disconnected, that is, there is no connection between the metal wires, or the plurality of metal wires may be connected at single terminals but do not form a loop, and projections of the metal wires on the base substrate layer are greater than or equal to an projection of the coil structure on the base substrate layer.

The following description will be provided in combination with the accompanying drawings by taking a heptagon as an example of a non-closed polygon.

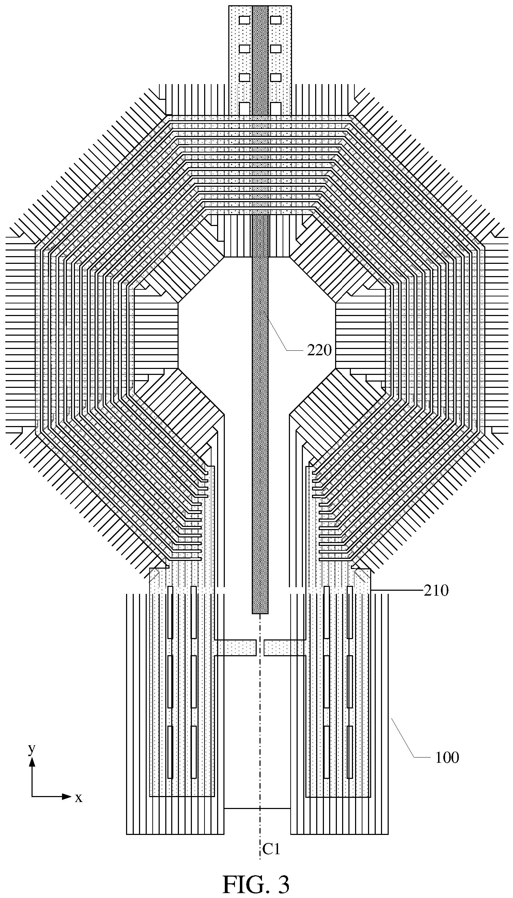

The second device structure layer 200 includes a first inductor layer 210 and a second inductor layer 220. Hereinafter, the shielding structure layer 100, the first inductor layer 210 and the second inductor layer 220 are mainly introduced, and the three layers are stacked from bottom to top in the order of the shielding structure layer 100, the first inductor layer 210 and the second inductor layer 220. FIG. 3 is a schematic diagram of a semiconductor device containing a first inductor, a second inductor, and a shielding structure.

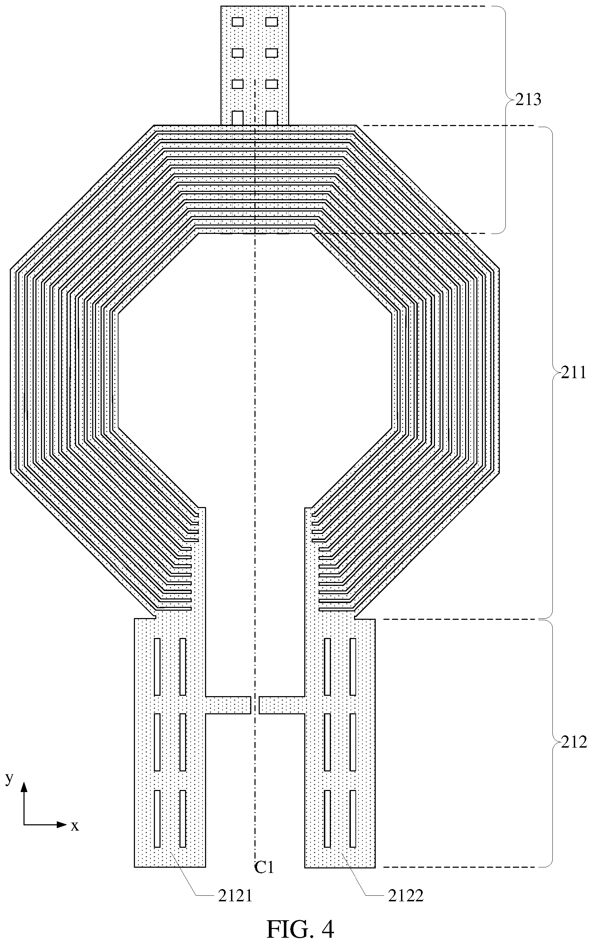

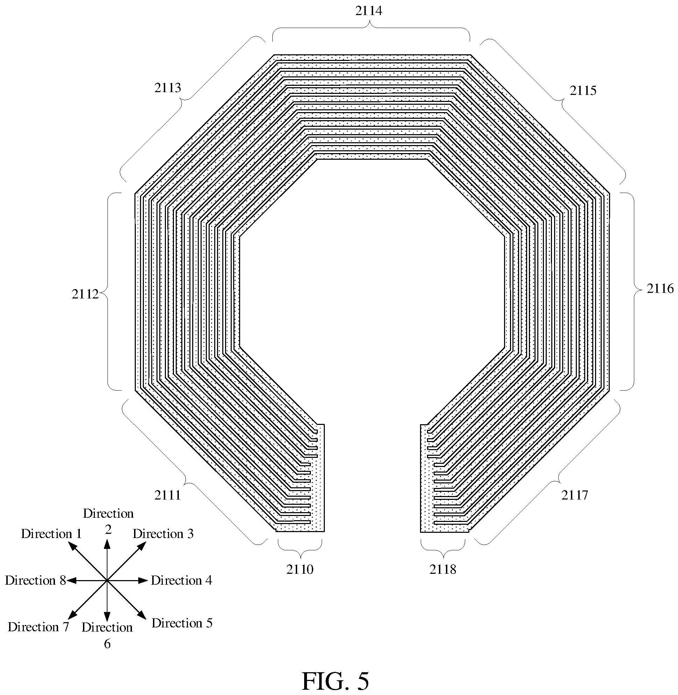

The first inductor layer 210 includes a first inductor 21, and in the present example, as shown in FIG. 4, the first inductor 21 includes an annular inductor structure 211, a first connection portion 212, and a second connection portion 213. The first connection portion 212, the annular inductor structure 211, and the second connection portion 213 are sequentially connected, and the second connection portion 213 is located on a side of the annular inductor structure 211 away from the first connection portion 212. The annular inductor structure 211 is a non-closed polygonal structure, it is a symmetrical structure, and its symmetry axis is C1. In the present example, as shown in FIG. 5, the annular inductor structure 211 is a regular octagonal structure as a whole, it can be understood that a shape of a region formed by connected outermost boundary points of the annular inductor structure 211 is a regular octagon. The annular inductor structure 211 includes a first segment 2111, a second segment 2112, a third segment 2113, a fourth segment 2114, a fifth segment 2115, a sixth segment 2116 and a seventh segment 2117 connected end-to-end, that is, it includes seven groups of metal strips (in the present example, each segment is equivalent to a previous group), and the terminals of the first segment 2111 (that is, the head segment) and the seventh segment 2117 (that is, the tail segment) that are not connected to other segments are the first terminal 2110 and the second terminal 2118 of the annular inductor structure, respectively. A first opening is formed between the first terminal 2110 and the second terminal 2118, and if the first terminal 2110 and the second terminal 2118 are connected, the annular inductor structure 211 is a regular octagon.

In the present example, the annular inductor structure 211 is composed of a plurality of metal strips arranged in parallel, and the number of metal strips may be 8 to 15, and in FIGS. 3 to 5 13 metal strips are taken as an example for illustration. Each metal strip may have a width of 2μm to 2.2μm (e.g., 2μm) and a spacing may be 1.5μm to 1.8μm (e.g., 1.5μm). The plurality of metal strips are connected at first terminal 2110 and second terminal 2118. The plurality of metal strips arranged at intervals in each segment are parallel to each other and extend towards the same direction. As shown in FIG. 5, the plurality of metal strips in the first segment 2111 extend towards the direction 1, the plurality of metal strips in the second segment 2112 extend towards the direction 2, the plurality of metal strips in the third segment 2113 extend towards the direction 3, the plurality of metal strips in the fourth segment 2114 extend towards the direction 4, the plurality of metal strips in the fifth segment 2115 extend towards the direction 5, the plurality of metal strips in the sixth segment 2116 extend towards the direction 6, and the plurality of metal strips in the seventh segment 2117 extend towards the direction 7. The first terminal 2110 of the annular inductor structure includes a plurality of parallel metal strips extending towards the direction 8 (each metal strip is connected in one-to-one correspondence with the plurality of metal strips of the first segment 2111), and a connection segment connected with the plurality of metal strips, and the second terminal 2118 of the annular inductor structure includes a plurality of parallel metal strips extending in the direction 4 (each metal strip is connected in one-to-one correspondence with the plurality of metal strips of the seventh segment 2117), and a connection segment connected with the plurality of metal strips. In the present example, direction 5 is an opposite direction of direction 1, direction 6 is an opposite direction of direction 2, direction 7 is an opposite direction of direction 3, and direction 8 is an opposite direction of direction 4. In the present example, lengths of the plurality of parallel metal strips in each segment (lengths in the direction in which the metal strips extend) are different, and lengths of the metal strips close to the center of the annular inductor structure are smaller than lengths of the metal strips away from the center of the annular inductor structure.

As shown in FIG. 4, the first connection portion 212 includes a first connection sub-portion 2121 and a second connection sub-portion 2122 symmetrically disposed. The first connection sub-portion 2121 and the second connection sub-portion 2122 are symmetrical with respect to the symmetry axis C1. The first connection sub-portion 2121 is connected with the first terminal 2110 of the annular inductor structure 211, and the second connection sub-portion 2122 is connected with the second terminal 2118 of the annular inductor structure 211. The first connection sub-portion 2121 includes a first main body structure and a first branch structure, wherein the first main body structure is connected with the first terminal 2110 of the annular inductor structure 211 and includes a plurality of metal strips extending along the direction y, and the first branch structure is connected with the first main body structure and is a rectangle (such as metal strips) extending along the direction x, that is, the first branch structure is connected with the metal strips, close to the second connection sub-portion, in the plurality of metal strips in the first main body structure. The second connection sub-portion 2122 is symmetrically disposed with the first connection sub-portion 2121, and includes a second main body structure and a second branch structure. The second main body structure is connected with the second terminal 2118 of the annular inductor structure 211 and includes a plurality of metal strips extending along the direction y, and the second branch structure is connected with the second main body structure and is a rectangular shape (such as metal strips) extending along an opposite direction of the direction x, that is, the second branch structure is connected with metal strips, close to the first connection sub-portion, in the plurality of metal strips in the second main body structure. The first branch structure and the second branch structure are symmetrically disposed as two connection terminals (an input terminal and an output terminal) of the first inductor, respectively. For the first inductor, a current flows in from one branch structure and flows out of the other branch structure, and a flow path of the current is curved, so that the metal wires in the corresponding shielding structure are vertical. In some other embodiments, the metal wires in the corresponding shielding structure may be inclined, that is, at a certain angle with the direction y. In some other examples, a position of the branch structure may be adjusted, for example, located at an end of the main body structure away from the annular inductor structure 211. In some other embodiments, the first main body structure and the second main body structure may be directly used as connection terminals without providing a branch structure.

The second connection portion 213 is located on a side of the annular inductor structure 211 away from the first connection portion 212, and is connected with the annular inductor structure 211. In the present example, the second connection portion 213 is of a rectangular structure extending along the direction y. Exemplarily, a projection of a center line of the second connection portion 213 along the direction y coincides with a projection of the symmetry axis of the annular inductor structure 211, for example, one terminal of the second connection portion 213 is connected with the fourth segment 2114 of the annular inductor structure 211, the second connection portion 213 and the first annular portion 211 may be connected in the same layer or by different layers, and the other terminal of the second connection portion 213 extends along the direction y and towards a direction away from the first connection portion 212. The second connection portion 213 serves as a power supply connection terminal of the first inductor.

In an exemplary embodiment, the first main body structure of the first connection sub-portion 2121 and the second main body structure of the second connection sub-portion 2122 may be formed in a parallel connection mode by a plurality of metal strips extending along the direction y at intervals, and the number of metal strips may be 3 to 5, and in FIGS. 3 and 4 three metal strips are taken as an example for illustration. Each metal strip may have a width of $10\mu m$-$14\mu m$ (e.g., $12\mu m$), and the spacing between the metal strips may be $1.6\mu m$ to $2.4\mu m$ (e.g., $2\mu m$). In FIGS. 3-4, the metal strips of the first main body structure of the first connection sub-portion 2121 and the second main body structure of the second connection sub-portion 2122 are connected in four places, and in some other examples they may be connected in two or three places, but the present example is not limited to this. In some other embodiments, the sizes of the metal strips of the first connection sub-portion 2121 and the second connection sub-portion 2122 may be the same as the size of the first annular portion 211 as long as the inductance parameter design requirements are satisfied.

The width and arrangement of intervals of the above-described metal strips may increase a surface area of the inductor. Since the inductor is inversely proportional to the frequency, the frequency can be reduced by increasing the inductor. The lower the frequency, the smaller the skin effect. Therefore, by setting the width and the spacing of the inductor metal strips, the losses caused by the skin effect of the inductor can be reduced. When the width and spacing of metal strips in the first inductor reach the DRC (Design rule check) limit allowed by the process, the surface area of the inductor is increased to the maximum, and the loss of the skin effect will be reduced to the minimum.

In the present example, the first inductor 21 may be made of a material of copper (Cu). In some other examples, the first inductor 21 may be made of other metallic materials, which are not limited in the present application.

The second inductor layer 220 includes a second inductor 22. As shown in FIG. 3, in the present example, the second inductor 22 is a strip-shaped structure (or a strip-like structure) extending along the direction y, the strip-shaped structure is symmetrical with respect to a second symmetry axis, and a projection of the second symmetry axis on the first inductor layer coincides with the first symmetry axis C1. The coincidence of the projections of the symmetry axes of the second inductor 22 and the first inductor 21 can reduce the influence of the electromagnetism/current of the first inductor on the electromagnetism/current of the second inductor, and the stacking of the two inductors can reduce the size of the semiconductor device. The projection of the second inductor 22 on the first inductor layer 210 does not exceed the first connection portion and the second connection portion in the direction y. For example, the second inductor 22 includes a first terminal and a second terminal, wherein a projection of the first terminal of the second inductor 22 on the first inductor layer 210 does not exceed an edge of the second connection portion 213 of the first inductor away from the first connection portion 212, and a projection of the second terminal of the second inductor 22 on the first inductor layer 210 does not exceed the branch structure in the first connection portion of the first inductor. Since the electromagnetic influences generated when the first inductor and the second inductor are on the same symmetry axis cancel each other, the mutual influence between the different inductors is minimized, so placing a slender second inductor at the position of the symmetry axis can not only achieve the circuit design of the oscillator, but also reduce the device area.

In an exemplary embodiment, a width (i.e. a length in the direction x) of the second inductor may be 4.4μm to 6.6μm (e.g. 5.5μm).

In the present example, the second inductor 22 may be made of a material of aluminum (Al). In some other examples, the second inductor 22 may be made of other metallic materials, which are not limited in the present application.

Since the second inductor 22 has a small inductance value, the second inductor 22 may be isolated using an insulation layer between the second inductor 22 and the first inductor 21, and in the present example, the second inductor 22 does not need a special isolation structure.

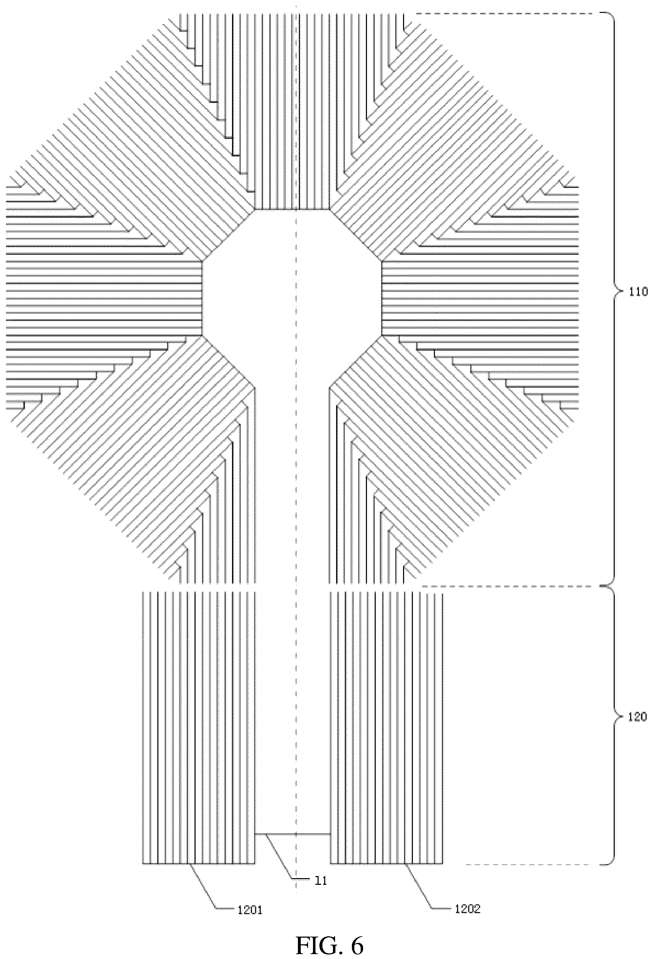

In the present example, as shown in FIG. 6, the first shielding structure for shielding interference of the first inductor in the shielding structure layer 100 includes two shielding structure portions, that is, a first shielding structure portion 110 and a second shielding structure portion 120. The first shielding structure portion 110 is configured to reduce an induced current of the annular inductor structure 211 in the first inductor, and the second shielding structure portion 120 is configured to reduce an induced current of the first connection portion 212 in the first inductor. A projection of the first shielding structure portion 110 on the shielding structure layer contains a projection of the annular inductor structure 211 on the shielding structure layer 100, and a projection of the second shielding structure portion 110 on the shielding structure layer is overlapped with a projection of the first connection portion 212 on the shielding structure layer 100.

In the present example, as illustrated in FIG. 6, the first shielding structure portion 110 and the second shielding structure portion 120 are provided at intervals, and by providing the first shielding structure portion 110 and the second shielding structure portion 120 to be insulated, formation of a current loop in the shielding structure, which increases losses, are prevented.

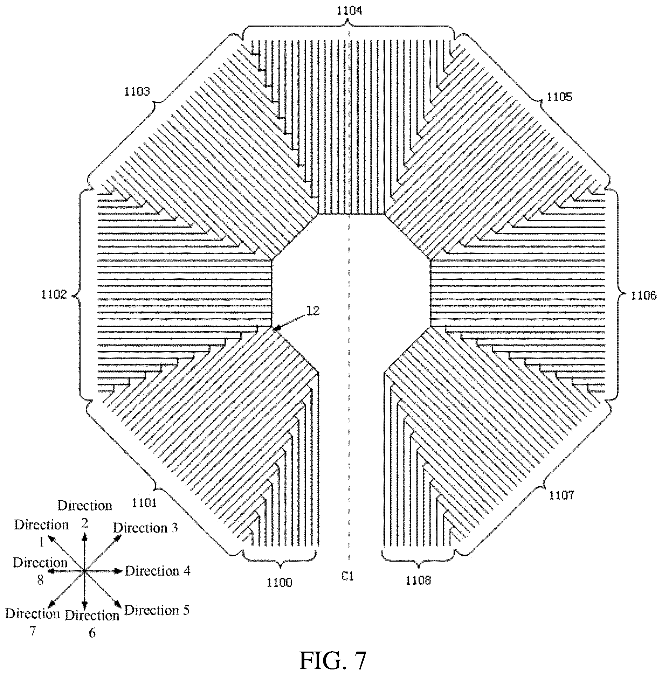

In the present example, as shown in FIG. 7, the first shielding structure portion 110 is similar to the annular inductor structure 211 in whole and shape, and includes a first sub-structure 1101, a second sub-structure 1102, a third sub-structure 1103, a fourth sub-structure 1104, a fifth sub-structure 1105, a sixth sub-structure 1106, and a seventh sub-structure 1107 which are connected to each other. Herein, a region of the first sub-structure 1101 contains a projection region of the first segment 2111 of the annular inductor structure 211 on the first shielding structure layer; a region of the second sub-structure 1102 includes a projection region of the second segment 2112 of the annular inductor structure 211 on the first shielding structure layer; a region of the third sub-structure 1103 includes a projection region of the third segment 2113 of the annular inductor structure 211 on the first shielding structure layer; a region of the fourth sub-structure 1104 contains a projection region of the fourth segment 2114 of the annular inductor structure 211 on the first shielding structure layer; a region of the fifth sub-structure 1105 contains a projection region of the fifth segment 2115 of the annular inductor structure 211 on the first shielding structure layer; and a region of the sixth sub-structure 1106 contains a projection region of the sixth segment 2116 of the annular inductor structure 211 on the first shielding structure layer; and a region of the seventh sub-structure 1107 contains a projection region of the seventh segment 2117 of the annular inductor structure 211 on the first shielding structure layer.

The first shielding structure portion 110 includes a plurality of metal wires extending along different directions, and there is no loop between the plurality of metal wires. The first shielding structure portion 110 includes a plurality of sub-structures, each of which includes a plurality of metal wires arranged in parallel, and an extension direction of the metal wires in each sub-structure depends on an extension direction of the metal strips in the annular inductor structure 211 located on the upper layer thereof. In the present example, an extension direction of the metal wires of each sub-structure is perpendicular to an extension direction of the metal strips of the annular inductor structure 211. Herein, an extension direction (direction 7) of a plurality of metal wires in the first sub-structure 1101 is perpendicular to an extension direction (direction 1) of a plurality of metal strips in the first segment 2111 of the annular inductor structure 211. An extension direction (direction 8) of a plurality of metal wires in the second sub-structure 1102 is perpendicular to an extension direction (direction 2) of a plurality of metal strips in the second segment 2112 of the annular inductor structure 211. An extension direction (direction 1) of a plurality of metal wires in the third sub-structure 1103 is perpendicular to an extension direction (direction 3) of a plurality of metal strips in the third segment 2113 of the annular inductor structure 211. An extension direction (direction 2) of a plurality of metal wires in the fourth sub-structure 1104 is perpendicular to an extension direction (direction 4) of a plurality of metal strips in the fourth segment 2114 of the annular inductor structure 211. An extension direction (direction 3) of a plurality of metal wires in the fifth sub-structure 1105 is perpendicular to an extension direction (direction 5) of a plurality of metal strips in the fifth segment 2115 of the annular inductor structure 211. An extension direction (direction 4) of a plurality of metal wires in the sixth sub-structure 1106 is perpendicular to an extension direction (direction 6) of a plurality of metal strips in the sixth segment 2116 of the annular inductor structure 211. An extension direction (direction 5) of a plurality of metal wires in the seventh sub-structure 1107 is perpendicular to an extension direction (direction 7) of a plurality of metal strips in the seventh segment 2117 of the annular inductor structure 211. In the present example, direction 5 is an opposite direction of direction 1, direction 6 is an opposite direction of direction 2, direction 7 is an opposite direction of direction 3, and direction 8 is an opposite direction of direction 4.

On the inside of the polygon, there is a metal wire 12, through which a plurality of sub-structures are connected together, i.e. the parallel metal wires in each sub-structure are finally connected to the inside annular connection wire 12. A width of the metal wire 12 may be the same as the width of the other metal wires in the shielding structure.

In an exemplary embodiment, a zeroth sub-structure 1100 and an eighth sub-structure 1108 may be further included, wherein the zeroth sub-structure 1100 includes a plurality of metal wires arranged in parallel, an extension direction (direction 6) of the plurality of metal wires is perpendicular to an extension direction (direction 8) of the plurality of metal strips in the first terminal 2110 of the annular inductor structure 211, the eighth sub-structure 1108 includes a plurality of metal wires arranged in parallel, and an extension direction (direction 6) of the plurality of metal wires is perpendicular to an extension direction (direction 4) of the plurality of metal strips in the second terminal 2118 of the annular inductor structure 211.

Each sub-structure contains metal wires connected sequentially but not forming a loop, and the metal wires in each sub-structure are connected with metal wires in an adjacent sub-structure thereto but not forming a loop. In an exemplary embodiment, a width of each metal wire in the first shielding structure 110 may be $0.68\mu m$ to $1.05\mu m$ (e.g., $0.85\mu m$), and a spacing between the metal wires may be $0.68\mu m$ to $1.05\mu m$ (e.g., $0.85\mu m$).

Through the above arrangement, on a plane where the shielding structure layer is located, the first shielding structure portion 110 contains an orthographic projection of the annular inductor structure 211 on the shielding structure layer 100, and an extension direction of the metal wires in the first shielding structure portion 110 is perpendicular to an extension direction of the metal strips in the annular inductor structure 211. A direction of a current induced by the shielding structure is opposite to a direction of a current in the metal strips of the annular inductor structure 211 in the upper layer thereof, such that the electric fields cancel each other in the shielding structure. In addition, the metal wires in the first shielding structure are isolated and disconnected from each other without forming a loop, so that the induced current between the shielding metals can be avoided. Accordingly, in the above-described embodiments the induced current can be reduced and the quality factor Q of the inductor can be improved.

In the present example, as shown in FIG. 6, the second shielding structure portion 120 includes a ninth sub-structure 1201 for shielding the first main body structure of the first connection sub-portion 2121 and a tenth sub-structure 1202 for shielding the second main body structure of the second connection sub-portion 2122, wherein the ninth sub-structure 1201 and the tenth sub-structure 1202 are disposed symmetrically with respect to a third symmetry axis whose projection on the first inductor layer coincides with the first symmetry axis C1. The ninth sub-structure 1201 includes a plurality of metal wires arranged in parallel, which are connected in a parallel connection mode through a connection wire and sequentially connected without a loop, so that the formation of induced current can be avoided. Optionally, the ninth sub-structure 1201 and the tenth sub-structure 1202 may communicate with each other through a connection metal wire (i.e., the above-described metal wire 12).

Since the current directions of the first connection sub-portion 2121 and the second connection sub-portion 2122 are different, the directions of the induced currents formed on the ninth sub-structure 1201 and the tenth sub-structure 1202 are opposite, and the electric fields are canceled by the metal wire 11 which connects the ninth sub-structure 1201 with the tenth sub-structure 1202. A width of the metal wire 11 is $3\mu m$ to $5\mu m$ (for example, $4\mu m$).

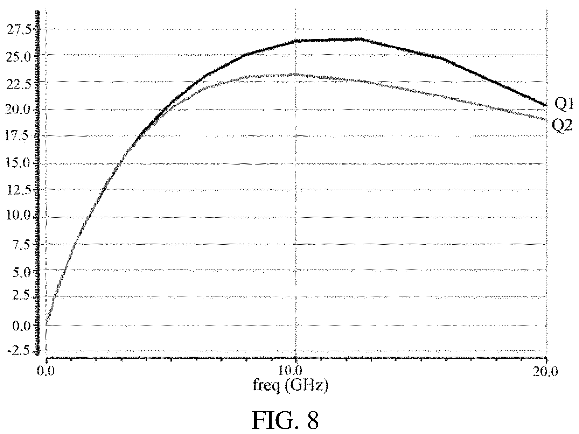

FIG. 8 is a simulation comparison diagram of Q values of an inductor (FIG. 3) adopting the shielding structure shown in FIG. 6 and an inductor without adopting the shielding structure. In the diagram, the curve Q1 is a simulation result of Q values of the inductor after the shielding structure of the present embodiment is adopted, and the maximum Q value may reach 26.5. The curve Q2 is a simulation result of Q values of the inductor without adopting the shielding structure, and the maximum Q value is 23. It can be seen that the Q value of the inductor can be significantly improved by adopting the shielding structure of the present embodiment.

In the above embodiment, the inductor may be applied in a voltage controlled oscillator (VCO) circuit in a radar sensor chip, thus the problem that the inductor in the VCO circuit in the radar sensor chip is easily radiated and leaked, resulting in signal interference to the circuit devices integrated on the base substrate of the semiconductor, can be solved. When the VCO formed with the above-described inductor is applied in the phase-locked loop (PLL) circuit of radio frequency, a 13GHz clock signal may be provided.

FIG. 9 is a partial schematic diagram of another oscillator according to an embodiment of the present disclosure. In the present example, in order to adapt to the needs of different clock circuits, a semiconductor structure having a high inductance value is provided. Similar to the inductor structure shown in FIG. 3, the inductor structure layer 200' in the present embodiment still includes a first inductor layer 210' and a second inductor layer 220', and some structures are different from the embodiment of FIG. 3. The shielding structure layer 100', the first inductor layer 210' and the second inductor layer 220' are mainly introduced below, and the three layers are stacked from bottom to top in an order of the shielding structure layer 100', first inductor layer 210' and second inductor layer 220'.

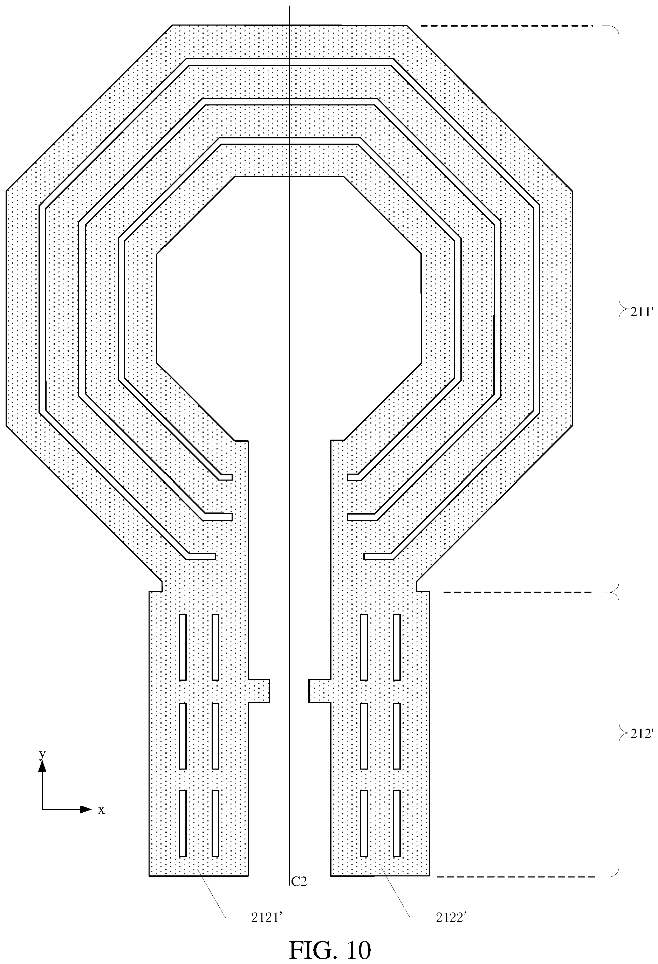

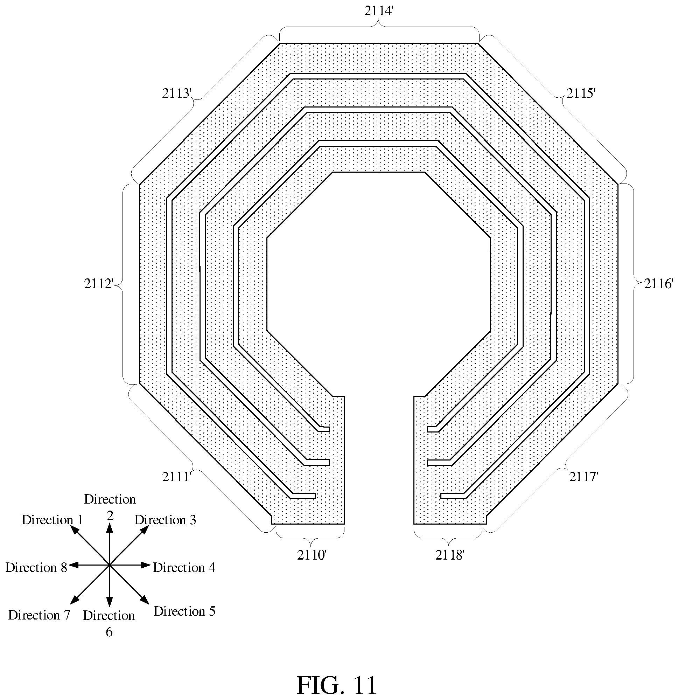

The first inductor layer 210' includes a first inductor 21', and as shown in FIG. 10, the first inductor 21' includes an annular inductor structure 211', a first connection portion 212', and a second connection portion 213' (not shown in the figure, but the position and the shape may be referred to the foregoing description and FIGS. 3 and 4). The annular inductor structure 211' is a non-closed polygonal structure and is a symmetrical structure, and its symmetrical axis is the fourth symmetrical axis (C2 in the figure). In the present example, as shown in FIG. 11, the annular inductor structure 211' is a regular octagonal structure as a whole, including a first segment 2111', a second segment 2112', a third segment 2113', a fourth segment 2114', a fifth segment 2115', a sixth segment 2116' and a seventh segment 2117' which are connected end-to-end, and terminals that are not connected to other segments are the first terminal 2110' and the second terminal 2118' of the annular inductor structure, respectively. A first opening is formed between the first terminal 2110' and the second terminal 2118', and if the first terminal 2110' and the second terminal 2118' are connected, the annular inductor structure 211' is a non-closed regular octagon.

In the present example, the annular inductor structure 211' is composed of a plurality of metal strips arranged in parallel, and the number of metal strips may be 3 to 5, and in FIGS. 9 to 11 4 metal strips are taken as an example for illustration. Each metal strip may have a width of 9μm to 14μm (e.g. 12μm) and a spacing may be 1.8μm to 2.2μm (e.g. 2.0μm). The plurality of metal strips are connected at a first terminal 2110' and a second terminal 2118', respectively. The plurality of metal strips arranged at intervals in each segment are parallel to each other and extend towards a same direction. As shown in FIG. 11, the plurality of metal strips in the first segment 2111' extend towards a direction 1, the plurality of metal strips in the second segment 2112' extend towards a direction 2, the plurality of metal strips in the third segment 2113' extend towards a direction 3, the plurality of metal strips in the fourth segment 2114' extend towards a direction 4, the plurality of metal strips in the fifth segment 2115' extend towards a direction 5, the plurality of metal strips in the sixth segment 2116' extend towards a direction 6, and the plurality of metal strips in the seventh segment 2117' extend towards a direction 7. The first terminal 2110' of the annular inductor structure includes a plurality of parallel metal strips extending towards a direction 8 (each metal strip is connected in one-to-one correspondence with the plurality of metal strips of the first segment 2111'), and a connection segment connected with the plurality of metal strips, and the second terminal 2118' of the annular inductor structure includes a plurality of parallel metal strips extending towards the direction 4 (each metal strip is connected in one-to-one correspondence with the plurality of metal strips of the seventh segment 2117'), and a connection segment connected with the plurality of metal strips. In the present example, direction 5 is an opposite direction of direction 1, direction 6 is an opposite direction of direction 2, direction 7 is an opposite direction of direction 3, and direction 8 is an opposite direction of direction 4. In the present example, lengths of the plurality of parallel metal strips in each segment (lengths in the direction in which the metal strips extend) are different, and lengths of the metal strips close to the center of the annular inductor structure are smaller than lengths of the metal strips away from the center of the annular inductor structure.

As shown in FIG. 10, the first connection portion 212' includes a first connection sub-portion 2121' and a second connection sub-portion 2122' symmetrically disposed, wherein the first connection sub-portion 2121' and the second connection sub-portion 2122' are symmetrical with respect to a symmetry axis C2, the first connection sub-portion 2121' is connected with the first terminal 2110' of the annular inductor structure 211', and the second connection sub-portion 2122' is connected with the second terminal 2118' of the annular inductor structure 211'. The first connection sub-portion 2121' includes a first main body structure and a first branch structure, wherein the first main body structure is connected to the first terminal 2110' of the annular inductor structure 211' and is a rectangle extending along a direction y, and the first branch structure is connected to the first main body structure and is a rectangle extending along a direction x. The second connection sub-portion 2122' is symmetrically disposed with the first connection sub-portion 2121' and includes a second main body structure and a second branch structure, wherein the second main body structure is connected with the second terminal 2118' of the annular inductor structure 211' and is a rectangle extending along the direction y, and the second branch structure is connected with the second main body structure and is a rectangle extending along an opposite direction of the direction x. In some other embodiments, the first branching structure and the second branching structure may be a square or other polygons, which are not limited herein.

Similar to the embodiment shown in FIG. 3, in the present embodiment, the first main body structure of the first connection sub-portion 2121' and the second main body structure of the second connection sub-portion 2122' may be formed in a parallel connection mode by a plurality of metal strips extending along the direction y at intervals, and the number of metal strips may be 3 to 5, and in FIGS. 9 and 10 three metal strips are taken as an example for illustration. Each metal strip may have a width of $10\mu m-14\mu m$ (e.g., $12\mu m$), and the metal strips may have a spacing of $1.6\mu m$ to $2.4\mu m$ (e.g., $2\mu m$). In FIGS. 9 and 10, the metal strips of the first main body structure of the first connection sub-portion 2121' and the second main body structure of the second connection sub-portion 2122' are connected in four places, and in some other examples they may be connected in two or three places, but the present example is not limited to this. In some other embodiments, the sizes of the metal strips of the first connection sub-portion 2121' and the second connection sub-portion 2122' may be the same as the size of the first annular portion 211' as long as the inductance parameter design requirements are satisfied.

In the present example, the first inductor 21' may be made of a material of copper (Cu). In some other examples, the first inductor 21' may be made of other metallic materials, which are not limited in the present application.

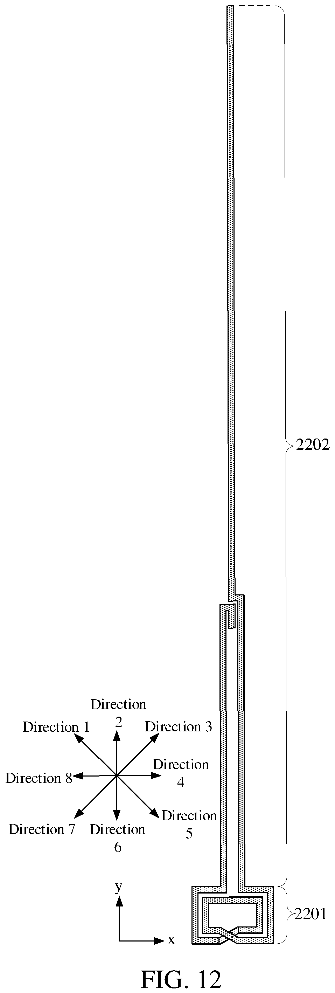

The second inductor layer 220' includes a second inductor 22'. As shown in FIGS. 9 and 12, in the present example, the second inductor 22' includes a coil structure 2201 and a strip-shaped structure 2202, and a projection of a center line of the second inductor 22' on the first inductor layer 210' coincides with a fourth symmetry axis C2. The coincidence between the projections of the center line of the second inductor 22' and the symmetry axis of the first inductor 21' can reduce the influence of the electromagnetism/current of the first inductor on the electromagnetism/current of the second inductor, and the stacking of the two inductors can reduce the size of the semiconductor device.

As shown in FIG. 12, the coil structure 2201 in the second inductor 22' is a structure obtained by rotating metal strips for two rounds, including two terminals facing the first inductor 21' (including the head terminal and the tail terminal), and each terminal is connected with a metal strip with the same width as that of the metal strip in the coil structure. In some other examples, the width of the connected metal strip may be different from the width of the metal strip in the coil structure. The head terminal of the coil structure is connected with a first metal strip, the tail terminal of the coil structure is connected with a second metal strip, the first metal strip and the second metal strip extend towards the same direction. In the figure, both metal strips extend towards the direction y and constitute the strip-shaped structure 2202 of the second inductor 22', and terminals of the two metal strips away from the coil structure serve as an input terminal and an output terminal of the second inductor 22', respectively. In the present example, rotation for two rounds of the coil structure is taken as an example, and in some other examples, rotation for multiple rounds may be made as needed.

In an exemplary embodiment, a width of the second inductor may be $4.4\mu m$ to $6.6\mu m$ (e.g., $5.5\mu m$), and the spacing between the metal strips may be $1.5\mu m$ to $1.8\mu m$ (e.g., $1.5\mu m$).

In the present example, the second inductor 22 may be made of a material of aluminum (Al). In some other examples, the second inductor 22 may be made of other metallic materials, which are not limited in the present application.

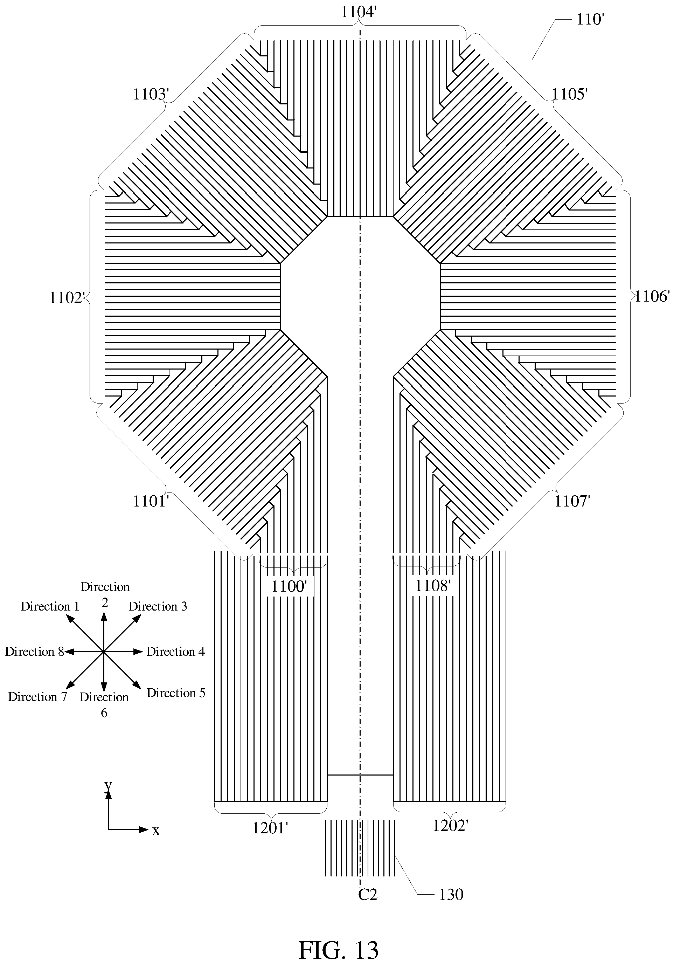

In the present example, the shielding structure layer 100' may include a plurality of shielding structures, as shown in FIG. 13, including two shielding structures: a first shielding structure 110' and the second shielding structure 130. The first shielding structure 110' in the present example includes a first portion and a second portion, wherein the first portion is similar to the shielding structure 110 shown in FIG. 6, and the second portion is similar to the shielding structure 120 shown in FIG. 6. The first shielding structure 110' is configured to reduce an induced current of the first inductor 21', and the second shielding structure 130 is configured to reduce an induced current of the second inductor 22'. A projection of the first shielding structure 110' on the shielding structure layer contains a projection of the first inductor 21' on the shielding structure layer 100'. A projection of the second shielding structure 130 on the shielding structure layer is overlapped with the second inductor 22', which may be overlapped with, for example, the coil structure 2201 of the second inductor 22', and the projection of the second shielding structure 130 on the shielding structure layer may contain the projection of the coil structure 2201 on the shielding structure layer.

As shown in FIG. 13, the first portion of the first shielding structure 110' is similar to the annular inductor structure 211' in whole and shape, and includes a first sub-structure 1101', a second sub-structure 1102', a third sub-structure 1103', a fourth sub-structure 1104', a fifth sub-structure 1105', a sixth sub-structure 1106', and a seventh sub-structure 1107' which are connected to each other. Herein, a region of the first sub-structure 1101' includes a projection region of the first segment 2111' of the annular inductor structure 211' on the first shielding structure layer, a region of the second sub-structure 1102' includes a projection region of the second segment 2112' of the annular inductor structure 211' on the first shielding structure layer, a region of the third sub-structure 1103' includes a projection region of the third segment 2113' of the annular inductor structure 211' on the first shielding structure layer, a region of the fourth sub-structure 1104' includes a projection region of the fourth segment 2114' of the annular inductor structure 211' on the first shielding structure layer, a region of the fifth sub-structure 1105' includes a projection region of the fifth segment 2115' of the annular inductor structure 211' on the first shielding structure layer, a region of the sixth sub-structure 1106' includes a projection region of the fifth segment 2116' of the annular inductor structure 211' on the first shielding structure layer, and a region of the sixth sub-structure 1107' includes a projection region of the fifth segment 2117' of the annular inductor structure 211' on the first shielding structure layer.

The first shielding structure 110' includes a plurality of metal wires extending along different directions, and there is no loop between the plurality of metal wires. The first portion of the first shielding structure 110' includes a plurality of sub-structures, each of which includes a plurality of metal wires arranged in parallel, and an extension direction of the metal wires in each sub-structure depends on an extension direction of the metal strips in the annular inductor structure 211' located on the upper layer thereof. In the present example, an extension direction of the metal wires of each sub-structure is perpendicular to an extension direction of the metal strips of the annular inductor structure 211'. Herein, an extension direction (direction 7) of the plurality of metal wires in the first sub-structure 1101' is perpendicular to an extension direction (direction 1) of the plurality of metal strips in the first segment 2111' of the annular inductor structure 211', an extension direction (direction 8) of the plurality of metal wires in the second sub-structure 1102' is perpendicular to an extension direction (direction 2) of the plurality of metal strips in the second segment 2112' of the annular inductor structure 211', an extension direction (direction 1) of the plurality of metal wires in the third sub-structure 1103' is perpendicular to an extension direction (direction 3) of the plurality of metal strips in the third segment 2113' of the annular inductor structure 211', an extension direction (direction 2) of the plurality of metal wires in the fourth sub-structure 1104' is perpendicular to an extension direction (direction 4) of the plurality of metal strips in the fourth segment 2114' of the annular inductor structure 211', an extension direction (direction 3) of the plurality of metal wires in the fifth sub-structure 1105' is perpendicular to an extension direction (direction 5) of the plurality of metal strips in the fifth segment 2115' of the annular inductor structure 211', an extension direction (direction 4) of the plurality of metal wires in the sixth sub-structure 1106' is perpendicular to an extension direction (direction 6) of the plurality of metal strips in the sixth segment 2116' of the annular inductor structure 211', and an extension direction (direction 5) of the plurality of metal wires in the seventh sub-structure 1107' is perpendicular to an extension direction (direction 7) of the plurality of metal strips in the seventh segment 2117' of the annular inductor structure 211'. In the present example, direction 5 is an opposite direction of direction 1, direction 6 is an opposite direction of direction 2, direction 7 is an opposite direction of direction 3, and direction 8 is an opposite direction of direction 4. As can be seen from the figure, the direction x is the same as direction 4, and the direction y is the same as direction 2.

In the present example, the first portion of the first shielding structure 110' further includes a zeroth sub-structure 1100' and an eighth sub-structure 1108', wherein the zeroth sub-structure 1100' in the present example is the same as the zeroth sub-structure 1100 in FIG. 7, and the eighth sub-structure 1108' in the present example is the same as the eighth sub-structure 1108 in FIG. 7. Herein, the zeroth sub-structure 1100' includes a plurality of metal wires arranged in parallel, and an extension direction (direction 6) of the plurality of metal wires is perpendicular to an extension direction (direction 8) of the plurality of metal strips in the first terminal 2110' of the annular inductor structure 211'. The eighth sub-structure 1108' includes a plurality of metal wires arranged in parallel, and an extension direction (direction 6) of the plurality of metal wires is perpendicular to an extension direction (direction 4) of the plurality of metal strips in the second terminal 2118' of the annular inductor structure 211'.

In the present example, the second portion of the first shielding structure 110' is similar to the shielding structure 120 shown in FIG. 6, and includes a ninth sub-structure 1201' and a tenth sub-structure 1202'. The ninth sub-structure 1201' in the present example is the same as the ninth sub-structure 1201 in FIG. 6, and the tenth sub-structure 1202' in the present example is the same as the tenth sub-structure 1202 in FIG. 6.

Each sub-structure contains metal wires connected sequentially but not forming a loop, and the metal wires in each sub-structure are connected with metal wires in an adjacent sub-structure thereto but not forming a loop. In an exemplary embodiment, a width of each metal wire in the first shielding structure 110' may be $0.68\mu m$ to $1.05\mu m$ (e.g., $0.85\mu m$), and a spacing between the metal wires may be $0.68\mu m$ to $1.05\mu m$ (e.g., $0.85\mu m$).

Through the above arrangement, on a plane where the shielding structure layer is located, a range of the first shielding structure 110' contains an orthographic projection of the first inductor 21' on the shielding structure layer 100, and an extension direction of the metal wires in the first shielding structure 110' is perpendicular to an extension direction of the metal strips in the annular inductor structure 211'. A direction of a current induced by the shielding structure is opposite to a current direction in the metal strips of the annular inductor structure 211 in the upper layer thereof, such that the electric fields cancel each other in the shielding structure. In addition, the metal wires in the first shielding structure are isolated and disconnected from each other without forming a loop, so that the induced current between the shielding metals can be avoided. Accordingly, in the above-described embodiment the induced current can be reduced and the quality factor Q of the inductor can be improved.

In the present example, as shown in FIG. 13, the second shielding structure 130 is configured to shield an induced current of the coil structure in the second inductor 22' and includes a plurality of metal wires arranged in parallel, and a center line of the second shielding structure coincides with a projection of a center line of the coil structure. A plurality of metal wires are arranged in parallel without a loop, which can avoid formation of an induced current.

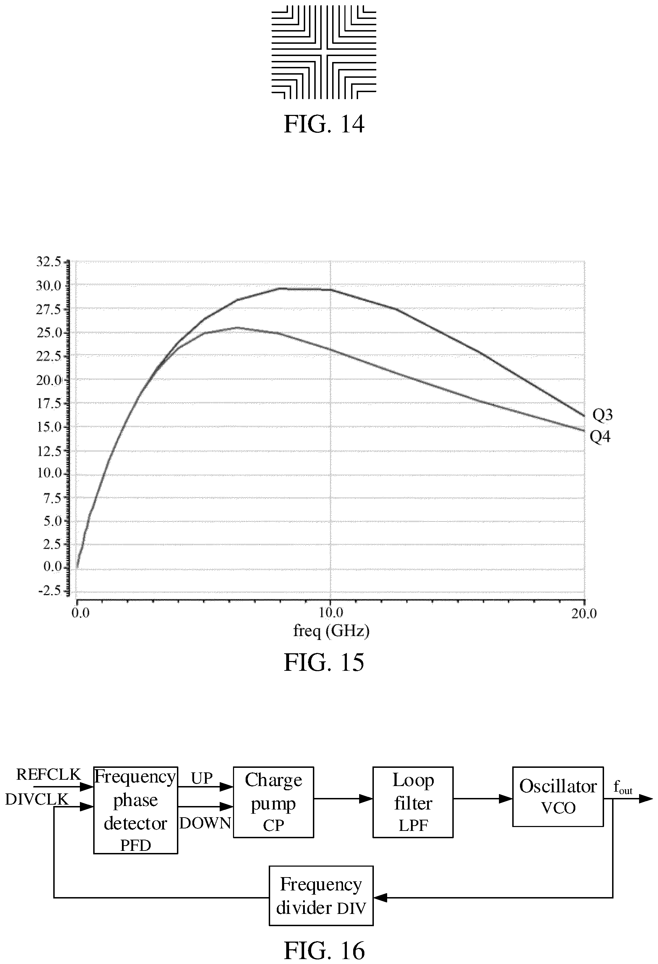

In another example, the second shielding structure 130 may adopt the structure as shown in FIG. 14, and the structure may ensure that the metal wires of the shielding structure are perpendicular to the metal strips in the inductor as much as possible to obtain a better shielding effect.

FIG. 15 is a simulation comparison diagram of Q values of an inductor (FIG. 9) adopting the shielding structure shown in FIG. 13 and an inductor without adopting the shielding structure. In the diagram, the curve Q3 is a simulation result of Q values of the inductor after the shielding structure of the present embodiment is adopted, and the maximum Q value may reach 30. The curve Q4 is a simulation result of Q values of the inductor without adopting the shielding structure, and the maximum Q value is 25. It can be seen that a Q value of an inductor can be significantly improved by adopting the shielding structure of the present embodiment.

In the above embodiment, the inductor may be applied in a voltage controlled oscillator (VCO) circuit in a radar sensor chip, thus the problem that the inductor in the VCO circuit in the radar sensor chip is easily radiated and leaked, resulting in signal interference to the circuit devices integrated on the base substrate of the semiconductor, can be solved. When the VCO formed with the above-described inductor is applied in the phase-locked loop (PLL) circuit of radio frequency, a 7.2GHz clock signal may be provided.

In some other embodiments, the above-described first inductor may also be of another polygonal structure, and accordingly, the shielding structure is also configured to be a corresponding shape, as long as the metal wires in the shielding structure and the metal strips in the inductor structure are perpendicular to each other. For example, the first inductor may be quadrangular, pentagonal, hexagonal, heptagonal, or nonagonal.

In some other embodiments, according to the application scenario of the semiconductor structure, only the first inductor may be contained in the semiconductor structure, for example, in the example of FIG. 6, only the inductor 21 and the first shielding structure 110 and the second shielding structure 120 for shielding the current induced by the inductor 21 are contained; and for another example, in the example of FIG. 9, only the inductor 21' and the first shielding structure 110' for shielding the current induced by the inductor 21' are contained. Or, in some other embodiments, other semiconductor devices may be contained in addition to the first inductor and the shielding structure for shielding the current induced by the first inductor. The present application is not limited thereto.

In some other embodiments, positions between the first device structure layer, the second device structure layer, and the shielding structure layer may be adjusted as needed, for example, positions of the first device structure layer and the second device structure layer may be interchanged, or positions between the first device structure layer and the shielding structure layer may be interchanged.

An embodiment of the present disclosure also provides a semiconductor structure, including a device structure layer (i.e., the foregoing second device structure layer) and a shielding structure layer that are disposed in insulation; the device structure layer is provided with at least one inductor device, and the shielding structure layer is provided with a first shielding structure for shielding an interference signal leaked by the inductor device.

The inductive device includes an annular inductor structure including a plurality of segments, which are sequentially connected to form a non-closed polygonal and symmetrical structure, and each segment includes a plurality of metal strips arranged in the same direction and in parallel.

The first shielding structure includes a plurality of sub-structures, each of which corresponds to a segment of the annular inductor structure and includes a plurality of metal wires arranged in parallel, wherein one terminal of each of metal wires is connected with an adjacent metal wire and the other terminal is disconnected to form a non-closed charge cancellation path, and an extension direction of the metal wires in each sub-structure is perpendicular to an extension direction of the metal strips in the annular inductor structure segment corresponding to the sub-structure.

By providing a shielding structure composed of metal wires below the metal strips of the inductor device, the extension direction of the metal wires in the shielding structure is perpendicular to the extension direction of the metal strips of the inductor device, and one terminal of each metal wire is connected with each other through a metal path and the other terminal is disconnected, the charge cancellation path thus formed may cancel the interference signals of different current directions leaked by a plurality of groups of metal strips in the inductor device as much as possible through the metal wires perpendicular to the current directions, so as to achieve the purpose of reducing the influence on other devices.

In an exemplary embodiment, the inductor device further includes a first connection portion connected with the annular inductor structure, and the first connection portion includes a first connection sub-portion and a second connection sub-portion. The first connection sub-portion includes a first main body structure and a first branch structure which are connected to each other and mutually perpendicular in the extension direction, and the first main body structure is connected with the head segment in a plurality of segments of the annular inductor structure. The second connection sub-portion includes a second main body structure and a second branch structure which are connected to each other and mutually perpendicular in the extension direction, and the second main body structure is connected with the tail segment in the plurality of segments of the annular inductor structure. The first branch structure and the second branch structure are an input terminal and an output terminal of the inductor device. The first connection sub-portion and the second connection sub-portion are symmetrically disposed, and its symmetry axis coincides with the symmetry axis of the annular inductor structure.

The shielding structure layer is further provided with a sub-structure for shielding the first connection sub-portion and a sub-structure for shielding the second connection sub-portion, an orthographic projection of the sub-structure for shielding the first connection sub-portion contains an orthographic projection of the first main body structure, and an orthographic projection of the sub-structure for shielding the second connection sub-portion contains an orthographic projection of the second main body structure; and each sub-structure includes a plurality of metal wires in a parallel connection mode without a loop, wherein each sub-structure includes a group of parallel metal wires arranged in a rectangle, one terminal portion of each metal wire of the same group of metal wires is connected to each other and the other terminal portion is disconnected, and the two sub-structures are connected through a metal wire, such that the two sub-structures as a whole form a non-closed charge cancellation path.

In an exemplary embodiment, the inductor device further includes a second inductor disposed in insulation from the annular inductor structure, the second inductor extends along a direction of the symmetry axis of the annular inductor structure, and an orthographic projection of the symmetry axis of the second inductor coincides with an orthographic projection of the symmetry axis of the annular inductor structure.

In an exemplary embodiment, the second inductor includes one or more of the following structures: a coil structure symmetrical with respect to the symmetry axis, a bent structure arranged along a direction of the symmetry axis, and a strip-shaped structure arranged along the direction of the symmetry axis.

In an exemplary embodiment, when the second inductor includes a coil structure symmetrical with respect to the symmetry axis of the annular inductor structure, the shielding structure layer is further provided with a second shielding structure for shielding a current induced by the coil structure in the second inductor, and the second shielding structure includes a plurality of metal wires without a loop.

A detailed description of the above-described embodiments may refer to the foregoing description, and will not be repeatedly described here.

FIG. 16 is a block diagram of a system of a phase-locked loop (PLL), including a frequency phase detector (PFD), a charge pump (CP), a filter (Low Pass Filter (LPF)), and an oscillator (Voltage Controlled Oscillator (VCO)) and a frequency divider (Divider (DIV)). The PLL is mainly used for generating a clock signal or Frequency Modulated Continuous Wave (FMCW) signal. As shown in FIG. 16, a first input terminal of the frequency phase detector PFD is an input terminal of the phase-locked loop PLL, a second input terminal of the PFD is connected to an output terminal of the frequency divider DIV, and an output terminal of the PFD is connected to an input terminal of the charge pump CP; and an output terminal of the charge pump CP is connected to an input terminal of the filter LPF, an output terminal of the filter LPF is connected to a control terminal of the oscillator VCO, and an output terminal of the oscillator VCO is connected to an input terminal of the frequency divider DIV. A reference clock signal REFCLK and a frequency division signal DIVCLK are input to the frequency phase detector PFD, which compares phases of REFCLK and DIVCLK to generate an error signal, also called a control signal (UP and DOWN), corresponding to a phase difference between the two signals, and then the signal is input to the charge pump CP. Under the control of the error signal, the charge pump CP adjusts an output current, the output current is filtered by the filter LPF and converted into a voltage signal, and is output to the VCO, the VCO adjusts a frequency of an output oscillator signal according to a voltage of the received voltage signal. The oscillation signal is divided by a frequency divider to obtain DIVCLK. When REFCLK and DIVCLK are in the same frequency and phase, it means that the PLL is locked. The voltage controlled oscillator VCO may be a voltage controlled oscillator contained the semiconductor integrated circuit of any of the foregoing embodiments. The phase-locked loop may be integrated in the foregoing semiconductor circuit.

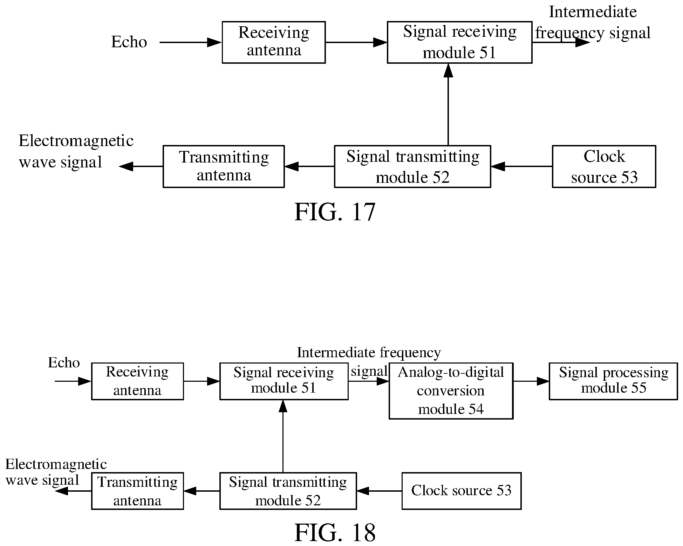

An embodiment of the present disclosure also provides a radar sensor, as shown in FIG. 17, including a signal receiving module 51, a signal transmitting module 52, and a clock source 53. The signal transmitting module 52 is configured to transmit an electromagnetic wave signal via a transmitting antenna based on a reference frequency provided by a phase-locked loop in the clock source 53, and the signal receiving module 51 is configured to receive an echo reflected by a target object using the receiving antenna, and perform down-conversion processing based on a radio frequency signal transmitted by the signal transmitting module 52 to generate and output an intermediate frequency signal; wherein the phase-locked loop is a phase-locked loop containing the voltage controlled oscillator.

Optionally, in an exemplary embodiment of the present disclosure, the frequency modulated continuous wave signal is a millimeter wave signal, such that the electronic apparatus may be applied to fields such as autonomous driving, industrial automation, smart home appliances, and security inspection.

As shown in FIG. 18, in an exemplary embodiment, the radar sensor may further include an analog-to-digital conversion module 54 and a signal processing module 55, wherein the signal receiving module 51 generates and outputs an intermediate frequency signal to the analog-to-digital conversion module 54, after the intermediate frequency signal is processed by the analog-to-digital conversion module 54, the processed signal is transmitted to the signal processing module 55, and signal processing is performed on the digital signal output by the analog-to-digital conversion module 54 by using the signal processing module 55.

For example, the signal transmitting module 52 generates a chirp signal according to a preset continuous frequency modulation mode; a radio frequency transmitting signal is obtained through frequency multiplication processing on the chirp signal, and then the radio frequency transmitting signal is fed to the transmitting antenna to transmit corresponding detection signal wave. When the detection signal wave is reflected by an object, an echo signal wave is formed. The echo signal wave is converted into a radio frequency receiving signal by a receiving antenna. The signal receiving module 51 is configured to perform down-conversion, filtering and the like on the radio frequency receiving signal by using the radio frequency transmitting signal, and then output a baseband digital signal representing a frequency difference between the detection signal wave and the echo signal wave after the analog-to-digital conversion processing is performed by the analog-to-digital conversion module 54. The signal processing module 55 is configured to extract measurement information from the baseband digital signal through signal processing and output measurement data. Herein, the signal processing includes carrying out digital signal processing and calculation such as processing in phase, in frequency, or in time domain, etc., on at least one signal to be processed provided by at least one receiving antenna. The measurement data includes at least one of the following: distance data for indicating a relative distance of the detected at least one obstacle; velocity data for indicating a relative velocity of the detected at least one obstacle; and angle data for indicating a relative angle of the detected at least one obstacle, etc.

Optionally, the frequency modulated continuous wave signal is a millimeter wave signal, the radar sensor may be an AiP millimeter wave radar chip integrated with an antenna, and in some other embodiments of the present application, the radar sensor may be another type of radar chip, which is not limited in the present application.

In an exemplary embodiment, an embodiment of the present disclosure further provides an electronic apparatus including the above-described phase-locked loop or the radar sensor.

Exemplarily, the electronic device includes: a device body, and an electronic device disposed on the device body, such as the phase-locked loop or the radar sensor according to the above-described embodiment. Herein, the device body is a structure which carries a radio device and is signal connected with the radio device. The radio device achieves functions such as target detection and/or communication within the range of beam scanning by transmitting and/or receiving the radio signal phase-shifted by the phaser, so as to provide detection target information and/or communication information to the device body, and further assist or even control the operation of the device body.

In an optional embodiment, the above electronic device containing the device body and the above-mentioned at least one radio device may be components and products applied to fields such as smart houses, transportation, smart homes, consumer electronics, monitoring, industrial automation, in-cabin detection and health care. For example, the device body may be a smart transportation device (such as an automobile, bicycle, motorcycle, ship, subway, train, etc.), a security device (such as a camera), a liquid level/flow rate detection device, a smart wearable device (such as a bracelet, glasses, etc.), a smart home device (such as a sweeping robot, a door lock, a television, an air conditioner, a smart light, etc.), various communication devices (such as a mobile phone, a tablet computer, etc.), as well as a road gate, a smart traffic light, a smart sign, a traffic camera and various industrial mechanical arms (or robots), etc. The device body may be various instruments for detecting vital signs parameters and various devices equipped with the instruments, such as a device for detection in automobile cabins, a device for indoor personnel monitoring, an intelligent medical device, a consumer electronic device, etc.

In the description of the embodiments of the present disclosure, it should be noted that an orientation or a positional relationship indicated by the terms "upper", "lower", "one side", "another side", "one terminal", "another terminal", "side", "opposite", "four corners", "periphery", a structure with a shape of a Chinese character "回" "and the like are the orientation or the positional relationship based on that shown in the accompanying drawings, which is only for convenience and simplification of the description of the embodiments of the present disclosure, rather than indicating or implying that the structure referred to must have the specific orientation, or be constructed and operated in the specific orientation, and thus those cannot be interpreted as a limitation on the present disclosure.

In the description of embodiments of the present disclosure, unless otherwise explicitly specified and defined, the terms "connection", "direct connection", "indirect connection", "fixed connection", "mounting", and "assembly" should be understood in a broad sense, for example, a connection may be a fixed connection, may also be a detachable connection, or an integrally connected. The terms "mount", "connected" and "fixed connection" may be direct connection or indirect connection through an intermediate medium, or may be internal communication of two elements. Those of ordinary skills in the art may understand meanings of the above-described terms in the present disclosure according to situations.

## Claims

1. A semiconductor integrated circuit, comprising: a base substrate layer, and a plurality of metal layers disposed on the base substrate layer and insulated from each other; wherein the plurality of metal layers comprise: a shielding structure layer, a first device structure layer, and a plurality of second device structure layers, and the semiconductor integrated circuit comprises an oscillator for outputting differential signals;

   the oscillator comprises a first inductor and a second inductor that are formed on different second device structure layers, a capacitor device formed on the first device structure layer, a first transistor and a second transistor that are formed on the base substrate layer; wherein the first inductor and the second inductor are symmetric with respect to a same symmetry axis; and
   the shielding structure layer is formed with a shielding structure for shielding interference signals leaked by the first inductor and/or the second inductor.

2. The semiconductor integrated circuit according to claim 1, wherein,
   the shielding structure comprises a plurality of metal wires, which are arranged to form a non-closed charge cancellation path; wherein the plurality of metal wires are arranged along a current direction of an inductor, and an extension direction of the plurality of metal wires is perpendicular to an orthographic projection of the current direction.

3. The semiconductor integrated circuit according to claim 1, wherein,
   an orthographic projection of the capacitor device on the base substrate layer does not coincide with an orthographic projection of the shielding structure on the base substrate layer.

4. The semiconductor integrated circuit according to claim 1, wherein a first terminal of the first inductor is connected with a first terminal of the capacitor device, a first electrode of the first transistor, and a control electrode of the second transistor; a second terminal of the first inductor is connected with a second terminal of the capacitor device, a first electrode of the second transistor and a control electrode of the first transistor; a control terminal of the first inductor is connected to a voltage terminal; a second electrode of the first transistor is connected with a first terminal of the second inductor; a second electrode of the second transistor is connected with the first terminal of the second inductor; a second terminal of the second inductor is grounded; the second electrode of the first transistor is connected with a first output terminal of the oscillator; the second electrode of the second transistor is connected with a second output terminal of the oscillator; and the first output terminal and the second output terminal of the oscillator output differential signals.

5. The semiconductor integrated circuit according to claim 1, wherein,
   the first inductor comprises a non-closed polygonal annular inductor structure, and a first connection portion connected with the annular inductor structure; the annular inductor structure is an axisymmetric structure and comprises a plurality of segments, which are sequentially connected to form a non-closed polygonal symmetric structure, a first segment in the plurality of segments is a head segment, the last segment in the plurality of segments is a tail segment, the first connection portion comprises a first connection sub-portion and a second connection sub-portion, the first connection sub-portion is connected with the head segment, the second connection sub-portion is connected with the tail segment, and a symmetry axis of the first connection sub-portion and the second connection sub-portion coincides with a symmetry axis of the annular inductor structure; and terminals of the first connection sub-portion and the second connection sub-portion which are not connected with the annular inductor structure are a first terminal and a second terminal of the first inductor, and the first terminal and the second terminal are symmetrically disposed.

6. The semiconductor integrated circuit according to claim 5, wherein,
   the first inductor further comprises a second connection portion, which is connected with the annular inductor structure and located on a side of the annular inductor structure away from the first connection portion, and the second connection portion is a control terminal of the first inductor.

7. The semiconductor integrated circuit according to claim 5, wherein,
the first connection sub-portion and the second connection sub-portion are rectangular inductor structures.

8. The semiconductor integrated circuit according to claim 6, wherein,
the shielding structure layer comprises a first shielding structure for shielding an induced current of the annular inductor structure, the first shielding structure comprises a plurality of sub-structures, each sub-structure corresponds to a segment of the annular inductor structure and comprises a plurality of metal wires disposed in parallel, and an extension direction of the metal wires in each sub-structure is perpendicular to an extension direction of metal strips in a segment of the annular transistor structure corresponding to the sub-structure.

9. The semiconductor integrated circuit according to claim 6 or 7, wherein,
the shielding structure comprises a sub-structure for shielding the first connection sub-portion and a sub-structure for shielding the second connection sub-portion; each sub-structure comprises a plurality of metal wires in a parallel connection mode without a loop, wherein each sub-structure comprises a group of parallel metal wires arranged in a rectangle, one terminal portion of each metal wire in a same group of metal wires is connected to each other and the other terminal portion of each metal wire in the same group of metal wires is disconnected, and the two sub-structures are connected through a metal wire, such that the two sub-structures as a whole form a non-closed charge cancellation path.

10. The semiconductor integrated circuit according to claim 5, wherein,

each segment of the annular transistor structure comprises a plurality of metal strips arranged in a same direction;
each segment of the annular transistor structure comprises 8 to 15 metal strips arranged in parallel, each metal strip has a width of $2\mu m$ to $2.2\mu m$, and a spacing between adjacent metal strips ranges from $1.5\mu m$ to $1.8\mu m$; or
each segment of the annular transistor structure comprises 3 to 5 metal strips arranged in parallel, each metal strip has a width of $9\mu m$ to $14\mu m$, and a spacing between adjacent metal strips ranges from $1.8\mu m$ to $2.2\mu m$.

11. The semiconductor integrated circuit according to claim 6, wherein,
a control terminal of the oscillator is located on the symmetry axis, and a first output terminal and a second output terminal of the oscillator are arranged symmetrically with respect to the symmetry axis.

12. The semiconductor integrated circuit according to claim 1, wherein,
the second inductor is provided as a metal structure extending along a direction of the symmetry axis, and a projection of the second inductor is partially or entirely located within a region enclosed and uncovered by a projection of the first inductor.

13. The semiconductor integrated circuit according to claim 1 or 12, wherein
the second inductor comprises one or more of the following structures: a coil structure symmetrical with respect to the symmetry axis, a bent structure arranged along a direction of the symmetry axis, and a strip-shaped structure arranged along the direction of the symmetry axis.

14. The semiconductor integrated circuit according to claim 1 or 12 or 13, wherein,
the metal strips in the second inductor have a width of $4.4\mu m$ to $6.6\mu m$, and a spacing between adjacent metal strips ranges from $1.5\mu m$ to $1.8\mu m$.

15. The semiconductor integrated circuit according to claim 1, wherein an orthographic projection of a first terminal and an orthographic projection of a second terminal of the second inductor are both located on the symmetry axis.

16. The semiconductor integrated circuit according to claim 1, wherein,
the shielding structure layer comprises a second shielding structure for shielding an induced current of the second inductor.

17. The semiconductor integrated circuit according to claim 1, wherein the first device structure layer is located between the second device structure layer and the shielding structure layer.

18. A phase-locked loop, integrated in the semiconductor circuit according to any one of claims 1 to 17, wherein the phase-locked loop comprises a frequency phase detector, a charge pump, a filter, and an oscillator and a frequency divider which are arranged in the semiconductor circuit; wherein,

a first input terminal of the frequency phase detector is an input terminal of the phase-locked loop, a second input terminal of the frequency phase detector is connected with an output terminal of the frequency divider, and an output terminal of the frequency phase detector is connected with an input terminal of the charge pump; and

an output terminal of the charge pump is connected with an input terminal of the filter, an output terminal of the filter is connected with a control terminal of the oscillator, and an output terminal of the oscillator is connected with an input terminal of the frequency divider.

19. A radar sensor, comprising a signal receiving module, a signal transmitting module, and a clock source, wherein the signal transmitting module is configured to transmit an electromagnetic wave signal via a transmitting antenna based on a reference frequency provided by a phase-locked loop in the clock source, and the signal receiving module is configured to receive an echo reflected by a target object using a receiving antenna, and perform down-conversion processing based on the reference frequency provided by the phase-locked loop in the clock source to generate and output an intermediate frequency signal; wherein the phase-locked loop is the phase-locked loop according to claim 18.

20. An electronic apparatus, comprising the phase-locked loop according to claim 18 or the radar sensor according to claim 19.

40
30
20
10

FIG. 1

VDD

L1

C1

Vout1 M1 M2 Vout2

L2

FIG. 2

220

210

100

y

x

C1

FIG. 3

213

211

213

212

2121

2122

C1

y

x

FIG. 4

FIG. 5

110

120

11

1201

1202

FIG. 6

FIG. 7

FIG. 8

FIG. 9

FIG. 10

FIG. 11

Direction
2
Direction 1   Direction 3

Direction 8   Direction
4

Direction 7   Direction   Direction
6   5

2202

2201

FIG. 12

FIG. 13

FIG. 14

FIG. 15

FIG. 16

Intermediate
frequency signal

Echo → Receiving antenna → Signal receiving module 51 → 

Signal receiving module 51 ← Signal transmitting module 52

Electromagnetic wave signal ← Transmitting antenna ← Signal transmitting module 52 ← Clock source 53

FIG. 17

Intermediate frequency signal

Echo → Receiving antenna → Signal receiving module 51 → Analog-to-digital conversion module 54 → Signal processing module 55

Signal receiving module 51 ← Signal transmitting module 52

Electromagnetic wave signal ← Transmitting antenna ← Signal transmitting module 52 ← Clock source 53

FIG. 18

## INTERNATIONAL SEARCH REPORT

| International application No. |
| --- |
| **PCT/CN2023/109342** |

### A. CLASSIFICATION OF SUBJECT MATTER

H01L23/552(2006.01)i; G01S7/02(2006.01)i; G01S7/36(2006.01)i; H01F27/36(2006.01)i

According to International Patent Classification (IPC) or to both national classification and IPC

### B. FIELDS SEARCHED

Minimum documentation searched (classification system followed by classification symbols)

IPC: H01L; G01S; H01F

Documentation searched other than minimum documentation to the extent that such documents are included in the fields searched

Electronic data base consulted during the international search (name of data base and, where practicable, search terms used)

CNTXT, ENTXT, ENTXTC, WPABS, DWPI, CNKI: 衬底, 电感, 电容, 晶体管, 干扰, 损耗, 屏蔽, 雷达, 锁相环, 振荡器, 压控振荡器, substrate, induct+, capacit+, transistor, interferen+, loss, shield+, radar, phase-locked loop, PLL, oscillator, VCO

### C. DOCUMENTS CONSIDERED TO BE RELEVANT

| Category* | Citation of document, with indication, where appropriate, of the relevant passages | Relevant to claim No. |
| --- | --- | --- |
| Y | CN 1574350 A (NEC ELECTRONICS CORP.) 02 February 2005 (2005-02-02) description, page 5, line 2 to page 9, line 4, and figures 3-5 | 1-20 |
| Y | CN 103518260 A (XILINX INC.) 15 January 2014 (2014-01-15) description, paragraphs [0042]-[0154], and figures 1-14 | 1-20 |
| Y | US 2012319787 A1 (TRIVEDI et al.) 20 December 2012 (2012-12-20) description, paragraphs [0015]-[0023], and figures 1-3 | 18-20 |
| A | CN 103794592 A (SEMICONDUCTOR MANUFACTURING INTERNATIONAL (SHANGHAI) CO., LTD.) 14 May 2014 (2014-05-14) entire document | 1-20 |
| A | CN 112671342 A (UNIVERSITY OF ELECTRONIC SCIENCE AND TECHNOLOGY OF CHINA) 16 April 2021 (2021-04-16) entire document | 1-20 |
| A | CN 203895449 U (SHANGHAI INTEGRATED CIRCUIT RESEARCH & DEVELOPMENT CENTER CO., LTD.) 22 October 2014 (2014-10-22) entire document | 1-20 |

☑ Further documents are listed in the continuation of Box C.    ☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **08 October 2023** | **12 October 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
|---|
| **PCT/CN2023/109342** |

**C.      DOCUMENTS CONSIDERED TO BE RELEVANT**

| Category* | Citation of document, with indication, where appropriate, of the relevant passages | Relevant to claim No. |
|---|---|---|
| A | CN 103633940 A (HARBIN INSTITUTE OF TECHNOLOGY) 12 March 2014 (2014-03-12) entire document | 1-20 |

Form PCT/ISA/210 (second sheet) (July 2022)

INTERNATIONAL SEARCH REPORT
Information on patent family members

International application No.

**PCT/CN2023/109342**

| Patent document cited in search report | | | Publication date (day/month/year) | Patent family member(s) | | | Publication date (day/month/year) |
|---|---|---|---|---|---|---|---|
| CN | 1574350 | A | 02 February 2005 | JP | 2005006153 | A | 06 January 2005 |
| | | | | US | 2009243110 | A1 | 01 October 2009 |
| | | | | US | 2004251978 | A1 | 16 December 2004 |
| | | | | US | 7088195 | B2 | 08 August 2006 |
| | | | | US | 2006139114 | A1 | 29 June 2006 |
| | | | | US | 7547970 | B2 | 16 June 2009 |
| | | | | CN | 1290190 | C | 13 December 2006 |
| | | | | CN | 1945834 | A | 11 April 2007 |
| CN | 103518260 | A | 15 January 2014 | JP | 2014514745 | A | 19 June 2014 |
| | | | | JP | 5859109 | B2 | 10 February 2016 |
| | | | | EP | 2689456 | A1 | 29 January 2014 |
| | | | | EP | 2689456 | B1 | 19 July 2017 |
| | | | | WO | 2012128832 | A1 | 27 September 2012 |
| | | | | KR | 20140026421 | A | 05 March 2014 |
| | | | | KR | 101797267 | B1 | 13 November 2017 |
| | | | | CN | 103518260 | B | 27 April 2016 |
| US | 2012319787 | A1 | 20 December 2012 | | None | | |
| CN | 103794592 | A | 14 May 2014 | US | 2014117496 | A1 | 01 May 2014 |
| | | | | US | 9209130 | B2 | 08 December 2015 |
| | | | | CN | 103794592 | B | 05 October 2016 |
| CN | 112671342 | A | 16 April 2021 | CN | 112671342 | B | 23 December 2022 |
| CN | 203895449 | U | 22 October 2014 | | None | | |
| CN | 103633940 | A | 12 March 2014 | CN | 103633940 | B | 04 May 2016 |

Form PCT/ISA/210 (patent family annex) (July 2022)

**REFERENCES CITED IN THE DESCRIPTION**

**Patent documents cited in the description**

- CN 202211358788